# EUROPÄISCHE PATENTSCHRIFT

(11) **EP 4 127 743 B1**
(45) Veröffentlichungstag und Bekanntmachung des Hinweises auf die Patenterteilung: **23.04.2025**
(21) Anmeldenummer: 21708191.8
(22) Anmeldetag: 24.02.2021
(51) Int. Cl.: G01R 31/08

(54) **SYSTEM FÜR EINE KABELSTRECKE, ÜBERTRAGUNGSSYSTEM ZUM ÜBERTRAGEN VON ELEKTRISCHER ENERGIE UND VERFAHREN ZUM BETRIEB DES SYSTEMS**
SYSTEM FOR A CABLE SECTION, TRANSMISSION SYSTEM FOR TRANSMITTING ELECTRIC ENERGY, AND METHOD FOR OPERATING THE SYSTEM
SYSTÈME POUR SECTION DE CÂBLE, SYSTÈME DE TRANSMISSION PERMETTANT DE TRANSMETTRE DE L'ÉNERGIE ÉLECTRIQUE ET PROCÉDÉ DE FONCTIONNEMENT DU SYSTÈME

(30) Priorität: 26.03.2020 DE 102020108382
(43) Veröffentlichungstag der Anmeldung: 08.02.2023
(73) Patentinhaber: Maschinenfabrik Reinhausen GmbH, 93059 Regensburg (DE)
(72) Erfinder: WINKELMANN, Erik, 01099 Dresden (DE); STEINER, Thomas, 01445 Radebeul (DE); BIRKHOLZ, Peter, 01159 Dresden (DE)
(86) Internationale Anmeldenummer: PCT/EP2021/054566
(87) Internationale Veröffentlichungsnummer: WO 2021/190849

(56) Entgegenhaltungen:
- DE-B3- 102018 126 743
- DE-T2- 60 020 050
- DE-T2- 69 333 936

## Beschreibung

Die Erfindung betrifft ein System für eine elektrische Kabelstrecke zur Übertragung von elektrischer Energie, ein Übertragungssystem zur Übertragung von elektrischer Energie, und ein Verfahren zum Betrieb des Systems für eine elektrische Kabelstrecke zur Übertragung von elektrischer Energie.

Elektrische Kabelstrecken zur Übertragung von elektrischer Energie sind aus dem Stand der Technik bekannt. Die Kabelstrecke kann aus einem einzelnen Kabelabschnitt oder aus einer Mehrzahl von hintereinander gekoppelten Kabelabschnitten bestehen. Die Kabelstrecke kann auch als elektrisches Kabel bezeichnet werden. Die Übertragung von elektrischer Energie über eine elektrische Kabelstrecke kann mittels Gleichspannung oder mittels Wechselspannung erfolgen. Um elektrische Energie über weite Entfernungen hinweg zu übertragen, werden oftmals sehr hohe Spannungen verwendet. In diesem Fall kann die Kabelstrecke als ein Hochspannungskabel ausgebildet sein. Die Kabelstrecke umfasst oftmals einen elektrisch leitenden Kern, der aus einer Vielzahl von einzelnen elektrisch leitfähigen Adern gebildet sein kann. Um den Kern herum sind oftmals mehrere Schichten aus unterschiedlichem Material und/oder mit unterschiedlichen Funktionen angeordnet. Eine der Schichten kann eine Isolationsschicht sein. In der Praxis kann es vorkommen, dass eine sogenannte Teilentladung stattfindet. Diese Teilentladung verursacht ein sprunghaftes elektrisches Signal, das sich von dem Ort der Teilentladung, der auch als Teilentladungsort bezeichnet wird, in entgegengesetzte Richtungen der Kabelstrecke ausbreitet. Das durch die Teilentladung verursachte Signal wird auch als Teilentladungssignal bezeichnet. Mit einem Sensor am Ende der Kabelstrecke kann das Teilentladungssignal erfasst werden. Zu berücksichtigen ist jedoch, dass das Teilentladungssignal auf der Wegstrecke zwischen dem Teilentladungsort und dem Sensor einer Dämpfung und Dispersion durch die physikalischen Eigenschaften der Kabelstrecke unterliegt. Die Dämpfung und die Dispersion hängen beispielsweise von den Frequenzanteilen des durch die Teilentladung verursachten Impulses, von dem strukturellen Aufbau der Kabelstrecke, von der Verlegeart der Kabelstrecke, von der Temperatur der Kabelstrecke und/oder von dem Alter der Kabelstrecke ab. Außerdem reicht ein einzelner Sensor an einem Ende der Kabelstrecke nicht aus. Vielmehr bedarf es eines zweiten Sensors an dem gegenüberliegenden Ende der Kabelstrecke, um über die Laufzeiten und Triangulation berechnen zu können, wo die Teilentladung stattgefunden hat bzw. wo der Teilentladungsort ist. Aufgrund der Abhängigkeit der Dämpfung und der Dispersion des Teilentladungssignals kommt es oftmals zu nicht unerheblichen Abweichungen zwischen dem errechneten Teilentladungsort und dem tatsächlichen Teilentladungsort. Aufgrund der zuvor genannten Dämpfung und Dispersion kann es darüber hinaus vorkommen, dass Teilentladungssignale einer derart starken Dispersion und/oder Dämpfung, insbesondere einer frequenzabhängigen Dämpfung, unterliegen, sodass diese von den Sensoren und/oder einer Auswerteeinrichtung nicht als Impulssignale erkannt werden. Deshalb besteht die Gefahr, dass bei Kabelstrecken Teilentladungen stattfinden, die nicht erkannt werden. Treten mehrere derartige Teilentladungen an dem gleichen Teilentladungsort auf, kann dies zu einer nicht unerheblichen Schädigung der Kabelstrecke führen, was zu vermeiden ist.

Dokument D60020050T2 nutzt die Eigenschaften von Teilentladungsimpulsen, die in einer Teilentladungsquelle erzeugt werden, in Abhängigkeit von der Strecke, die sie im elektrischen System beispielsweise entlang eines Leiters zurücklegen. Durch die Ableitung charakteristischer Parameter, die bestimmte Eigenschaften der Teilentladungsimpulse angeben, aus gemessenen Teilentladungsimpulsen und durch Einsetzen der Parameter in ein vorab z. B. experimentell erstelltes Modell, das die Änderung der charakteristischen Parameter in Abhängigkeit von der Strecke im Wesentlichen bei den Frequenzen, bei denen Teilentladungsimpulse auftreten, beschreibt, ist es möglich, den Abstand einer Quelle von Teilentladungen zum Messpunkt mit einer gewissen Genauigkeit zu bestimmen.

Der Erfindung liegt die Aufgabe zugrunde, ein System und ein zugehöriges Verfahren bereitzustellen, die eine sichere Erkennung einer Teilentladung und eine präzise Bestimmung eines Abstands des Teilentladungsorts zum Sensor erlaubt.

Gemäß einem ersten Aspekt der Erfindung wird die zuvor genannte Aufgabe gelöst durch ein System mit den Merkmalen des Anspruchs 1. Vorgesehen ist also ein System für eine elektrische Kabelstrecke zur Übertragung von elektrischer Energie. Das System weist einen ersten Sensor zur Erfassung elektrischer Signale der Kabelstrecke, eine Prozessoreinheit, einen Datenspeicher und eine Signalschnittstelle auf. Der Datenspeicher hat eine erste Kurvenmenge aus mehreren ersten Kurven mit jeweils einem zugehörigen Abstand zum ersten Sensor gespeichert, wobei jede erste Kurve eine mittels eines Kabelmodells der Kabelstrecke vorbestimmte Impulsantwort eines elektrischen Impulses durch eine modellierte Teilentladung in dem für die jeweilige erste Kurve zugehörigen Abstand zum ersten Sensor an der Kabelstrecke repräsentiert. Der erste Sensor ist zur Erfassung eines elektrischen Signals ausgebildet, das als erstes Entladungssignals bezeichnet wird und durch eine tatsächliche Teilentladung an der Kabelstrecke verursacht ist. Außerdem ist der erste Sensor zur direkten oder indirekten Übertragung eines ersten Messsignals an die Prozessoreinheit ausgebildet, wobei das erste Messsignal das erste Entladungssignal repräsentiert. Die Prozessoreinheit ist konfiguriert, basierend auf dem ersten Messsignal eine der ersten Kurven der ersten Kurvenmenge als erste Entladungskurve zu bestimmen, die unter den ersten Kurven der ersten Kurvenmenge am Besten mit dem ersten Entladungssignal korreliert. Welche der ersten Kurven der ersten Kurvenmenge am Besten mit dem ersten Entladungssignal übereinstimmt bzw. korreliert, kann durch die Anwendung von Ähnlichkeitsmaßen im Merkmalsraum, wie beispielsweise Euklidischer Abstand, Mahalanobis-Distanz und/oder Kosinus-Ähnlichkeit, ermittelt werden. Die Prozessoreinheit ist konfiguriert, einen ersten Sensorabstand der tatsächlichen Teilentladung zum ersten Sensor basierend auf dem zur ersten Entladungskurve zugehörigen Abstand zu bestimmen. Die Signalschnittstelle ist ausgestaltet, ein Ausgangssignal zu übertragen, das den ersten Sensorabstand repräsentiert.

Durch Untersuchungen wurde festgestellt, dass die Teilentladung an einer elektrischen Kabelstrecke durch einen elektrischen Impuls modelliert werden kann. Außerdem wurde festgestellt, dass die Kabelstrecke durch ein mathematisches Modell, nämlich das Kabelmodell, modellierbar ist, das durch eine Vielzahl von Parameter einstellbar ist. Diese Parameter können so eingestellt sein, dass das Modell eine tatsächliche Kabelstrecke modelliert. Wird dieses Kabelmodell nun dazu verwendet, um eine Teilentladung durch einen modellierten Impuls an einem Teilentladungsort der modellierten Kabelstrecke zu verursachen, so kann mit dem gleichen Kabelmodell die Impulsantwort an einem Ende der Kabelstrecke oder an einem anderen Sensorort an der Kabelstrecke ermittelt werden. Die Impulsantwort oder zumindest ein Teil der Impulsantwort bildet sodann eine Kurve. Die Impulsantwort bzw. die Kurve ändert sich, wenn der Abstand zwischen dem modellierten Ort für den Sensor und dem modellierten Ort für das Einspeisen des elektrischen Impulses geändert wird. Es ist deshalb möglich, für eine Vielzahl von unterschiedlichen Abständen jeweils zugehörige Kurven mittels des Kabelmodells zu ermitteln. Diese Kurven können die mehreren ersten Kurven mit einem jeweils zugehörigen Abstand zum ersten Sensor bilden, die im Datenspeicher gespeichert sind. Die ersten Kurven unterscheiden sich dabei sowohl in ihrem Frequenzspektrum als auch im Amplitudenspektrum. So wurde beispielsweise festgestellt, dass umso größer der modellierte Abstand zwischen dem Teilentladungsort und dem Sensor ist, desto niederfrequenter ist das Frequenzspektrum der Kurve und außerdem ist auch die Größe der maximalen Amplitude kleiner.

Bezüglich des Systems ist es deshalb bevorzugt vorgesehen, dass der Datenspeicher eine erste Kurvenmenge aus mindestens 10 ersten Kurven, mindestens 20 ersten Kurven oder mindestens 30 ersten Kurven gespeichert hat. Die zu den ersten Kurven zugehörigen Abstände zum Sensor können eine Reihe aus jeweils größeren Abständen bilden, wobei die Abstände äquidistant zueinander ausgestaltet sind.

Wenn von dem ersten Sensor ein elektrisches Signal der Kabelstrecke erfasst wird, kann dieses mit den ersten Kurven verglichen werden, um zu ermitteln, welche der Kurven am Besten zu dem erfassten Signal passt. Dieser Kurve ist ein Abstand zugeordnet, der in dem Datenspeicher gespeichert ist. Dieser Abstand entspricht dann dem tatsächlichen Abstand des ersten Sensors zu der tatsächlichen Teilentladung an der elektrischen Kabelstrecke.

Es ist deshalb vorgesehen, dass der erste Sensor zur Erfassung eines elektrischen Signals ausgebildet ist, das als erstes Entladungssignal bezeichnet wird und durch eine tatsächliche Teilentladung an der Kabelstrecke verursacht ist. Der erste Sensor kann außerdem ein erstes Messsignal an die Prozessoreinheit übertragen, wobei das erste Messignal das erfasste, erste Entladungssignal repräsentiert. Das erste Entladungssignal ist für gewöhnlich ein analoges Signal. Das erste Messsignal ist hingegen bevorzugt ein digitales Signal. Dies bietet den Vorteil, dass keine Verschlechterung an Informationen bezüglich des erfassten, ersten Entladungssignals bei der Übertragung zu der Prozessoreinheit entsteht. Der erste Sensor kann deshalb dazu ausgebildet sein, das erfasste, erste Entladungssignal zu digitalisieren und daraus das erste Messsignal zu bilden.

Durch die Übertragung des ersten Messsignals an die Prozessoreinheit erhält die Prozessoreinheit nicht nur die Information über das erste Messsignal als solches sondern auch Informationen über das erste Entladungssignal, das von dem ersten Messsignal repräsentiert ist. Die Prozessoreinheit kann somit unter der Mehrzahl der ersten Kurven der ersten Kurvenmenge die Kurve heraussuchen, die das erfasste, erste Entladungssignal am Besten wiedergibt. Deshalb ist die Prozessoreinheit dazu konfiguriert, basierend auf dem ersten Messsignal eine der ersten Kurven der mehreren ersten Kurven als erste Entladungskurve zu bestimmen, die unter den ersten Kurven der ersten Kurvenmenge am Besten mit dem ersten Entladungssignal korreliert. So kann die Prozessoreinheit beispielsweise dazu konfiguriert sein, eine Autokorrelation für jede der ersten Kurven mit der ersten Entladungskurve auszuführen, sodass durch das Ausführen jeder der Autokorrelationsfunktionen ein Autokorrelationswert entsteht. Die erste Kurve, zu der der größte Autokorrelationswert ermittelt wurde, ist dann die Kurve unter den ersten Kurven der ersten Kurvenmenge, die am Besten mit dem ersten Entladungssignal korreliert. Grundsätzlich gibt es jedoch auch andere Methoden zur Bestimmung der Kurve unter den ersten Kurven der ersten Kurvenmenge, die am Besten mit dem ersten Entladungssignal korreliert. Die entsprechende Kurve wird als erste Entladungskurve bezeichnet.

Die Prozessoreinheit ist vorzugsweise mit dem Datenspeicher gekoppelt, sodass die Prozessoreinheit auf den Datenspeicher zugreifen kann. Insbesondere kann die Prozessoreinheit dazu konfiguriert sein, die Daten zu den ersten Kurven und den zugehörigen Abständen aus dem Datenspeicher auszulesen. Zuvor wurde erläutert, dass die Prozessoreinheit dazu konfiguriert ist, die erste Entladungskurve zu bestimmen. Diese erste Entladungskurve ist eine der mehreren ersten Kurven, die im Datenspeicher gespeichert ist. Zu jeder ersten Kurve ist im Datenspeicher ein Abstand gespeichert, der den Abstand der Teilentladung zum Sensor repräsentiert. Die Prozessoreinheit ist deshalb bevorzugt dazu konfiguriert, den zu der ersten Entladungskurve zugehörigen Abstand aus dem Datenspeicher auszulesen. Es ist deshalb vorgesehen, dass die Prozessoreinheit konfiguriert ist, einen ersten Sensorabstand der tatsächlichen Teilentladung zum ersten Sensor basierend auf dem zur ersten Entladungskurve zugehörigen Abstand zu bestimmen. Vorzugsweise ist der erste Sensorabstand der zur ersten Entladungskurve zugehörige Abstand.

Die erste Kurvenmenge wurde zuvor mit einem Kabelmodell bestimmt, das besonders präzise an die tatsächliche Kabelstrecke angepasst sein kann. Somit kann von dem Kabelmodell auch die tatsächliche Dämpfung und/oder Dispersion für Impulse berücksichtigt werden, die durch Teilentladungen entstehen. Die ersten Kurven der ersten Kurvenmenge unterscheiden sich vorzugsweise sowohl in ihrem Frequenzgang als auch in ihrem Amplitudengang. Dies erlaubt eine besonders präzise Stimmung der ersten Kurve unter den ersten Kurven der ersten Kurvenmenge, die am Besten zu dem ersten Entladungssignal passt. Es sind also vorzugsweise der Amplitudengang und der Frequenzgang, die Einfluss darauf haben, welche der ersten Kurven dabei als erste Entladungskurve bestimmt wird. In der Praxis wurde festgestellt, dass die erste Entladungskurve unter der Mehrzahl der ersten Entladungskurven so präzise bestimmbar ist, dass der zu der ersten Entladungskurve zugehörige erste Sensorabstand besonders präzise den tatsächlichen Abstand des Sensors zum Teilentladungsort angibt, an dem die Teilentladung stattgefunden hat.

Das System weist außerdem eine Signalschnittstelle auf, die ausgestaltet ist, ein Ausgangssignal zu übertragen, das den ersten Sensorabstand repräsentiert. Insbesondere kann das Ausgangssignal von der Signalschnittstelle gesendet werden. Dadurch ist der erste Sensorabstand für weitere Bauteile, Vorrichtungen und/oder Systeme zugänglich. Insbesondere kann das System weitere Module und/oder Einheiten aufweisen, die zur Weiterverarbeitung des ersten Sensorabstands ausgebildet sind. Es ist deshalb auch möglich, dass die Signalschnittstelle einen integralen Teil der Prozessoreinheit bildet. Die Prozessoreinheit und die Signalschnittstelle können also integral ausgebildet sein.

Der erste Sensor des Systems kann zur wiederholten und/oder periodischen Erfassung eines elektrischen Signals ausgebildet sein. Hieraus resultiert, dass mit jeder Erfassung eines elektrischen Signals auch eine erste Entladungskurve und ein erster Sensorabstand bestimmt wird. Die Prozessoreinheit kann dazu entsprechend ausgebildet sein. Außerdem kann die Signalschnittstelle so ausgebildet sein, das Ausgangssignal derart zu übertragen, dass der jeweils aktuellste Sensorabstand übertragen wird. Das Ausgangssignal kann also periodisch die zuvor bestimmten, ersten Sensorabstände übertragen. Die periodische Erfassung elektrischer Signale mit dem ersten Sensor bietet den Vorteil, dass eine kontinuierliche Überwachung der elektrischen Kabelstrecke mittels des Systems stattfinden kann.

Eine vorteilhafte Ausgestaltung des Systems zeichnet sich dadurch aus, dass das System einen zweiten Sensor zur Erfassung elektrischer Signale der Kabelstrecke aufweist. Der Datenspeicher hat vorzugsweise eine zweite Kurvenmenge aus mehreren zweiten Kurven mit jeweils einem zugehörigen Abstand zum zweiten Sensor gespeichert, wobei jede zweite Kurve eine mittels des Kabelmodells der Kabelstrecke vorbestimmte Impulsantwort eines elektrischen Impulses durch eine modellierte Teilentladung in dem für die jeweilige zweite Kurve zugehörigen Abstand zum zweiten Sensor an der Kabelstrecke repräsentiert. Außerdem sind der erste Sensor und der zweite Sensor in einem vorbestimmten Sensorabstand voneinander an der Kabelstrecke befestigbar. Der zweite Sensor ist vorzugsweise zur Erfassung eines elektrischen Signals ausgebildet, das als zweites Entladungssignals bezeichnet wird und durch die gleiche, tatsächliche Teilentladung an der Kabelstrecke verursacht ist. Ferner ist der zweite Sensor vorzugsweise zur direkten oder indirekten Übertragung eines zweiten Messsignals an die Prozessoreinheit ausgebildet, das das zweite Entladungssignal repräsentiert. Die Prozessoreinheit ist vorzugsweise konfiguriert, basierend auf dem zweiten Messsignal eine der zweiten Kurven der zweiten Kurvenmenge als zweite Entladungskurve zu bestimmen, die unter den zweiten Kurven am Besten mit dem zweiten Entladungssignal korreliert. Welche der zweiten Kurven der zweiten Kurvenmenge am Besten mit dem zweiten Entladungssignal übereinstimmt bzw. korreliert, kann durch die Anwendung von Ähnlichkeitsmaßen im Merkmalsraum, wie beispielsweise Euklidischer Abstand, Mahalanobis-Distanz und/oder Kosinus-Ähnlichkeit, ermittelt werden. Darüber hinaus ist die Prozessoreinheit vorzugsweise derart konfiguriert, den ersten Sensorabstand der tatsächlichen Teilentladung zum ersten Sensor basierend auf dem vorbestimmten Sensorabstand, dem der ersten Entladungskurve zugehörigen Abstand und dem der zweiten Entladungskurve zugehörigen Abstand zu bestimmen.

Das System weist also zusätzlich zu dem ersten Sensor einen weiteren, nämlich den zweiten Sensor auf. Der zweite Sensor ist ebenfalls zur Erfassung von elektrischen Signalen ausgebildet. Der erste und zweite Sensor sind in dem vorbestimmten Sensorabstand an der Kabelstrecke befestigbar. Vorzugsweise ist der erste Sensor an einem ersten Ende der Kabelstrecke befestigbar und der zweite Sensor an einem zweiten, gegenüberliegenden Ende der Kabelstrecke befestigbar. Tritt eine Teilentladung an der Kabelstrecke auf, verursacht diese ein impulsartiges Signal, das als elektrisches Signal von den beiden Sensoren erfasst wird. Insbesondere aufgrund der Dämpfung und der Dispersion der elektrischen Kabelstrecke gelangen jedoch unterschiedliche elektrische Signale zu den beiden Sensoren. Ist der Abstand vom Teilentladungsort zum ersten Sensor beispielsweise geringer als zum zweiten Sensor, so wird das erste Entladungssignal eine größere Amplitude im hochfrequenten Spektralanteil aufweisen als das zweite Entladungssignal. Da das erste Entladungssignal und das zweite Entladungssignal in der Praxis oftmals unterschiedlich sind, kann zu jedem der beiden Entladungssignale jeweils eine zugehörige Entladungskurve bestimmt werden.

Es ist deshalb bevorzugt vorgesehen, dass der Datenspeicher eine zweite Kurvenmenge aus mehreren zweiten Kurven mit jeweils einem zugehörigen Abstand zum zweiten Sensor gespeichert hat. Bezüglich der zweiten Kurvenmenge, der zweiten Kurven und den zugehörigen Abständen wird in analoger Weise auf die vorteilhaften Erläuterungen, bevorzugten Merkmale, technischen Effekte und/oder Vorteile Bezug genommen, wie sie bereits zu der ersten Kurvenmenge, den ersten Kurven und den dazu zugehörigen Abständen erläutert worden sind. Grundsätzlich kann es vorgesehen sein, dass der Datenspeicher also eine erste Kurvenmenge und eine zweite Kurvenmenge gespeichert hat. Die beiden Kurvenmengen können unterschiedlich sein. Es ist aber auch möglich, dass die erste Kurvenmenge und die zweite Kurvenmenge gleich sind. In diesem Fall kann der Datenspeicher eine gemeinsame Kurvenmenge gespeichert haben, die sowohl die erste Kurvenmenge als auch die zweite Kurvenmenge bildet. Für die zugehörigen Abstände gilt analoges.

Der zweite Sensor kann analog zu dem ersten Sensor ausgebildet sein. Für den zweiten Sensor wird deshalb in analoger Weise auf die vorteilhaften Erläuterungen, bevorzugten Merkmale, technischen Effekte und/oder Vorteile Bezug genommen, wie sie im Zusammenhang mit dem ersten Sensor erläutert worden sind. Es ist jedoch darauf hinzuweisen, dass das erste Entladungssignal und das zweite Entladungssignal durch die gleiche, tatsächliche Teilentladung an der Kabelstrecke verursacht sind. Aufgrund des oftmals unterschiedlichen Abstands vom Teilentladungsort zu den beiden Sensoren und/oder aufgrund unterschiedlicher physikalischer Gegebenheiten unterscheidet sich das erste Entladungssignal zumeist von dem zweiten Entladungssignal.

Es ist deshalb auch bevorzugt vorgesehen, dass die Prozessoreinheit konfiguriert ist, die zweite Entladungskurve unter den zweiten Kurven der zweiten Kurvenmenge zu bestimmen, die am Besten mit dem zweiten Entladungssignal korreliert. Außerdem kann die Prozessoreinheit dazu konfiguriert sein, den zu der zweiten Entladungskurve zugehörigen Abstand aus dem Datenspeicher auszulesen. Entsprechendes kann vorgesehen sein für die erste Entladungskurve. So kann die erste Prozessoreinheit konfiguriert sein, den zu der ersten Entladungskurve zugehörigen Abstand aus dem Datenspeicher auszulesen. Im Idealfall ergibt eine Addition der beiden ausgelesenen Abstände den vorbestimmten Sensorabstand zwischen den beiden Sensoren. Daraus folgt, dass der erste Sensorabstand, nämlich der Abstand zwischen dem Ort der tatsächlichen Teilentladung an der elektrischen Kabelstrecke, (Teilentladungsort) und dem ersten Sensor durch den zu der ersten Teilentladungskurve zugehörigen Abstand bestimmt ist. Gleichermaßen ist der erste Sensorabstand aber auch durch Subtraktion des zu der zweiten Entladungskurve zugehörigen Abstands von dem vorbestimmten Sensorabstand bestimmt. In diesem Fall kann die Prozessoreinheit dazu konfiguriert sein, den ersten Sensorabstand redundant basierend auf dem vorbestimmten Sensorabstand, dem der ersten Entladungskurve zugehörigen Abstand und dem der zweiten Entladungskurve zugehörigen Abstand zu bestimmen. Denn die Prozessoreinheit kann dazu ausgebildet sein, die zuvor genannten mathematischen Schritte auszuführen. Entspricht die Differenz des vorbestimmten Sensorabstands und dem zu der zweiten Entladungskurve zugehörigen Abstand nicht dem zu der ersten Entladungskurve zugehörigen Abstand, kann der erste Sensorabstand beispielsweise durch Mittelwertbildung von der zuvor genannten Differenz und dem zu der ersten Entladungskurve zugehörigen Abstand bestimmt werden. Die Prozessoreinheit kann dazu entsprechend konfiguriert sein. Durch die Berücksichtigung der Abstände, die zu der ersten und zweiten Entladungskurve gehören, kann der erste Sensorabstand noch präziser bestimmt werden.

Eine weitere vorteilhafte Ausgestaltung des Systems zeichnet sich dadurch aus, dass das System eine erste Impulseinspeiseeinheit zur Einspeisung mindestens eines ersten, elektrischen Impulses in die Kabelstrecke aufweist. Die Prozessoreinheit ist konfiguriert, Parameter des Kabelmodells zu verändern, das ein Übertragungsverhalten von elektrischen Impulsen über die Kabelstrecke repräsentiert. Die Prozessoreinheit ist ferner ausgebildet, die erste Impulseinspeiseeinheit zu steuern, so dass als erste Referenzimpulse bezeichnete, elektrische Impulse mittels der ersten Impulseinspeiseeinheit in die Kabelstrecke eingespeist werden, wobei die erste Impulseinspeiseeinheit beabstandet von dem ersten Sensor angeordnet ist. Der erste Sensor ist zur Erfassung elektrischer Signale ausgebildet, die als erste Referenzsignale bezeichnet und durch die ersten Referenzimpulse verursacht sind. Ferner ist der erste Sensor zur direkten oder indirekten Übertragung eines ersten Testsignals an die Prozessoreinheit ausgebildet, wobei das erste Testsignal die ersten Referenzsignale repräsentiert. Darüber hinaus ist die Prozessoreinheit konfiguriert, die Parameter des Kabelmodells basierend auf dem ersten Testsignal anzupassen, so dass das von dem Kabelmodell repräsentierte Übertragungsverhalten zu dem durch die ersten Referenzimpulse und die ersten Referenzsignale repräsentierten, tatsächlichen Übertragungsverhalten der Kabelstrecke entspricht.

Im Zusammenhang mit dem System wurde bereits erläutert, dass der Datenspeicher eine erste Kurvenmenge aus mehreren ersten Kurven gespeichert haben kann, wobei jede erste Kurve dieser ersten Kurven der ersten Kurvenmenge mittels eines Kabelmodells der Kabelstrecke vorbestimmt sein kann. Das Kabelmodell kann beispielsweise in dem Datenspeicher des Systems gespeichert sein. Außerdem kann das Kabelmodell beispielsweise von der Prozessoreinheit geladen werden, um dieses auszuführen. Das Kabelmodell kann durch Parameter veränderbar sein. Durch die Änderung der Parameter des Kabelmodells kann das modellierte Übertragungsverhalten von elektrischen Impulsen über die Kabelstrecke verändert werden. Die Parameter des Kabelmodells können beispielsweise angepasst werden, um ein anderes Dämpfungs- und/oder Dispersionsverhalten der Kabelstrecke mittels des Kabelmodells zu modellieren. Die Parameter können beispielsweise dazu verwendet werden, um eine frequenzspezifische Dämpfung und/oder eine ortsspezifische Dämpfung und/oder eine frequenzspezifische Dispersion und/oder eine frequenzspezifische Dispersion zu verursachen. Indem die Prozessoreinheit dazu konfiguriert ist, die Parameter des Kabelmodells zu verändern, kann das Übertragungsverhalten der Kabelstrecke besonders präzise an das tatsächliche Übertragungsverhalten der Kabelstrecke angepasst werden. Für die erstmalige Verwendung des Kabelmodells können vorbestimmte Parameter verwendet werden. Um die Parameter des Kabelmodells jedoch an das tatsächliche Übertragungsverhalten anzupassen und damit eine präzise Modellierung zu erreichen, sind Testsignale von Vorteil.

Die Prozessoreinheit ist deshalb dazu ausgebildet, die erste Impulseinspeiseeinheit derart zu steuern, sodass als erste Referenzimpulse bezeichnete, elektrische Impulse mittels der ersten Impulseinspeiseeinheit in die Kabelstrecke eingespeist werden. Diese Einspeisung erfolgt vorzugsweise in einem Abstand zu dem ersten Sensor. Dieser Abstand der ersten Impulseinspeiseeinheit von dem ersten Sensor kann vorbestimmt und/oder bekannt sein. Wie zuvor erläutert, erfasst der erste Sensor elektrische Signale. Der erste Sensor erfasst deshalb auch das als erstes Referenzsignal bezeichnete und durch den ersten Referenzimpuls verursachte elektrische Signal. Darüber hinaus ist der erste Sensor zur Übertragung eines Testsignals an die Prozessoreinheit ausgebildet, wobei das erste Testsignal das erste Referenzsignal repräsentiert. Für gewöhnlich ist das erste Referenzsignal ein Analogsignal. Um den Informationsgehalt nicht zu verschlechtern, kann der erste Sensor dazu ausgebildet sein, das erste Referenzsignal zu digitalisieren, um daraus das erste Testsignal zu bilden. Außerdem ist der erste Sensor ausgebildet, um das erste Testsignal an die Prozessoreinheit zu übertragen.

Außerdem kann die Prozessoreinheit derart mit der Impulseinspeiseeinheit gekoppelt sein, um ein Steuersignal an die erste Impulseinspeiseeinheit zu senden, sodass der erste Referenzimpuls in die Kabelstrecke eingespeist wird. Das Steuersignal kann den ersten Referenzimpuls repräsentieren. Alternativ oder ergänzend ist es möglich, dass die Prozessoreinheit Daten zumindest temporär speichert, die den ersten Referenzimpuls repräsentieren. Alternativ oder ergänzend ist es möglich, dass ein Signal von der Impulseinspeiseeinheit an die Prozessoreinheit gesendet wird, nachdem der erste Referenzimpuls eingespeist wurde, wobei dieses Signal den ersten Referenzimpuls repräsentiert.

Durch die Einspeisung des ersten Referenzimpulses wird das erste Referenzsignal verursacht, das von dem ersten Sensor erfasst wird. Die Prozessoreinheit kann deshalb dazu konfiguriert sein, das tatsächliche Übertragungsverhalten der Kabelstrecke basierend auf dem ersten Referenzimpuls und dem ersten Referenzsignal zu ermitteln. Da der Ort bekannt ist, an dem die Impulseinspeiseeinheit den ersten Referenzimpuls in die Kabelstrecke einspeist, kann das Kabelmodell auch dazu verwendet werden, um ein von dem Kabelmodell repräsentiertes Übertragungsverhalten zu modellieren, das auftreten würde, wenn ein zu dem ersten Referenzimpuls korrespondierender Impuls in die von dem Kabelmodell modellierte Kabelstrecke an dem theoretisch gleichen Ort eingespeist wird. Vor diesem Hintergrund ist die Prozessoreinheit deshalb dazu konfiguriert, die Parameter des Kabelmodells basierend auf dem ersten Testsignal derart anzupassen, sodass das von dem Kabelmodell repräsentierte Übertragungsverhalten dem durch die ersten Referenzimpulse und die ersten Referenzsignale repräsentierten, tatsächlichen Übertragungsverhalten der Kabelstrecke entspricht. Dies gilt zumindest dann, wenn hierzu die Kabelstrecke mittels des Kabelmodells von der Prozessoreinheit derart modelliert wird, dass in die modellierte Kabelstrecke Impulse eingespeist werden, die zu den ersten Referenzimpulsen korrespondieren, sodass zu den ersten Referenzsignalen korrespondierende Hilfssignale mittels des Kabelmodells erzeugt werden. Denn mit diesen Hilfssignalen und den zuvor genannten Impulsen kann das durch das Kabelmodell repräsentierte Übertragungsverhalten in entsprechender Weise mit dem tatsächlichen Übertragungsverhalten der Kabelstrecke verglichen werden. Die Anpassung der Parameter des Kabelmodells erfolgt dabei in der Weise, dass eine möglichst geringe Differenz zwischen dem von dem Kabelmodell repräsentierten Übertragungsverhalten und dem tatsächlichen Übertragungsverhalten der Kabelstrecke entsteht. Die Differenz bezieht sich dabei vorzugsweise auf dem Amplitudengang und/oder den Frequenzgang.

Durch die Anpassung der Parameter des Kabelmodells lässt sich das Kabelmodell deshalb besonders einfach an die tatsächlichen Gegebenheiten der tatsächlichen Kabelstrecke anpassen. Dies gilt insbesondere für die erstmalige Inbetriebnahme. Es ist jedoch auch möglich, dass das Kabelmodell während des Betriebs mehrfach durch Veränderung der Parameter angepasst wird. So kann es in der Praxis vorkommen, dass starke Teilentladungen dazu führen, dass sich die Dämpfung und/oder die Dispersion der Kabelstrecke an bestimmten Stellen ändert. Diese Dämpfung und/oder Dispersion kann sich insbesondere im Hinblick auf dem Amplitudengang oder im Hinblick auf den Frequenzgang ändern. Durch die Anpassung der Parameter des Kabelmodells kann diesen Änderungen Rechnung getragen werden. Ist eine neue Anpassung der Parameter des Kabelmodells mittels der Prozessoreinheit ausgeführt, kann die Prozessoreinheit dazu konfiguriert sein, die erste Kurvenmenge und/oder die zweite Kurvenmenge neu zu bestimmen. Außerdem kann die Prozessoreinheit dazu konfiguriert sein, die neue, erste Kurvenmenge in dem Datenspeicher abzuspeichern. Entsprechendes kann für die neue, zweite Kurvenmenge sowie für die Abstände gelten. Dadurch ist es wiederum möglich, dass der erste Sensorabstand im fortlaufenden Betrieb weiterhin besonders präzise bestimmt werden kann, und zwar insbesondere auch dann, wenn die Kabelstrecke Veränderungen unterliegt.

Die Parameter des Kabelmodells können das Übertragungsverhalten beispielsweise in Bezug auf einen Amplitudengang, einen Phasengang, eine Gruppenlaufzeit, eine Phasenlaufzeit, eine relative Permittivität der Kabelstrecke und/oder andere Eigenschaften der Kabelstrecke beeinflussen. Dadurch lässt sich das Kabelmodell besonders präzise an die tatsächliche Kabelstrecke anpassen.

Es hat sich als vorteilhaft herausgestellt, wenn der erste Sensor an einem Ende der Kabelstrecke und die erste Impulseinspeiseeinheit den ersten Referenzimpuls an dem gegenüberliegenden Ende der Kabelstrecke einspeist. Denn in diesem Fall muss der erste Referenzimpuls durch die gesamte Leitungsstrecke übertragen werden, bevor ein entsprechendes, von diesem ersten Referenzimpuls verursachtes, erstes Referenzsignal von dem ersten Sensor erfasst wird. Dieses erste Referenzsignal eignet sich deshalb besonders vorteilhaft, um die Parameter des Kabelmodells anzupassen.

Zuvor wurde bereits erläutert, dass es bevorzugt vorgesehen sein kann, dass das System zwei Sensoren, nämlich den ersten Sensor und den zweiten Sensor aufweist. Außerdem ist es bevorzugt vorgesehen, dass der erste Sensor an einem Ende der Kabelstrecke und der zweite Sensor an dem gegenüberliegenden Ende der Kabelstrecke angeordnet wird. An diesem gegenüberliegenden Ende wird vorzugsweise, wie zuvor erläutert, der erste Referenzimpuls eingespeist.

Eine vorteilhafte Ausgestaltung des Systems zeichnet sich dadurch aus, dass das System eine zweite Impulseinspeiseeinheit zur Einspeisung mindestens eines zweiten, elektrischen Impulses in die Kabelstrecke aufweist. Die Prozessoreinheit ist ausgebildet, die zweite Impulseinspeiseeinheit zu steuern, so dass als zweite Referenzimpulse bezeichnete, elektrische Impulse mittels der zweiten Impulseinspeiseeinheit in die Kabelstrecke eingespeist werden, wobei die zweite Impulseinspeiseeinheit beabstandet von dem zweiten Sensor angeordnet ist. Der zweite Sensor ist zur Erfassung elektrischer Signale ausgebildet, die als zweite Referenzsignale bezeichnet und durch die zweiten Referenzimpulse verursacht sind. Ferner ist der zweite Sensor zur direkten oder indirekten Übertragung eines zweiten Testsignals an die Prozessoreinheit ausgebildet, das die zweiten Referenzsignale repräsentiert. Die Prozessoreinheit ist konfiguriert, die Parameter des Kabelmodells basierend auf dem ersten Testsignal und dem zweiten Testsignal anzupassen, so dass das von dem Kabelmodell repräsentierte Übertragungsverhalten dem durch die ersten Referenzimpulse und die ersten Referenzsignale und/oder durch die zweiten Referenzimpulse und zweiten Referenzsignale repräsentierten, tatsächlichen Übertragungsverhalten der Kabelstrecke entspricht.

Für die zweite Impulseinspeiseeinheit, den zweiten Referenzimpuls, das zweite Referenzsignal und das zweite Testsignal wird auf die vorangegangenen Erläuterungen, bevorzugten Merkmale, technischen Effekte und/oder Vorteile in analoger Weise Bezug genommen, wie sie im Zusammenhang mit der ersten Impulseinspeiseeinheit, den ersten Referenzimpulsen, den ersten Referenzsignalen und dem ersten Testsignal erläutert worden sind. Zu beachten ist jedoch, dass die zweite Impulseinspeiseeinheit beabstandet von dem zweiten Sensor angeordnet ist. So kann die zweite Impulseinspeiseeinheit beispielsweise derart angeordnet sein, dass die zweite Impulseinspeiseeinheit die zweiten Referenzimpulse an dem gleichen Ende einspeist, wo auch der erste Sensor angeordnet ist. Der zweite Sensor ist vorzugsweise an dem gegenüberliegenden Ende der Kabelstrecke angeordnet, wo vorzugsweise auch die erste Impulseinspeiseeinheit die ersten Referenzimpulse einspeist. Die von der zweiten Impulseinspeiseeinheit eingespeisten Referenzimpulse müssen also von der Kabelstrecke zu dem zweiten Sensor an dem gegenüberliegenden Ende übertragen werden, wo sie als zweite Referenzsignale erfasst werden. Durch die Übertragung unterliegen die einspeisten Referenzimpulse jedoch einer frequenzabhängigen und/oder amplitudenabhängigen Dämpfung und/oder Dispersion.

Grundsätzlich kann das zweite Testsignal in analoger Weise wie das erste Testsignal verwendet werden, um die Parameter des Kabelmodells anzupassen. Die Parameter des Kabelmodells können jedoch noch genauer angepasst werden, wenn diese Anpassung basierend auf dem ersten Testsignal und dem zweiten Testsignal erfolgt. Die Anpassung kann dabei in der Art von der Prozessoreinheit ausgeführt werden, sodass das von dem Kabelmodell repräsentierte Übertragungsverhalten zu dem durch die ersten Referenzimpulse und die ersten Referenzsignale repräsentierten, tatsächlichen Übertragungsverhalten der Kabelstrecke sowie zu dem durch die zweiten Referenzimpulse und die zweiten Referenzsignale repräsentierten, tatsächlichen Übertragungsverhalten der Kabelstrecke entspricht. Durch die entsprechend genaue Anpassung der Parameter des Kabelmodells können, wie zuvor erläutert, die erste Kurvenmenge und/oder die zweite Kurvenmenge aktualisiert werden, die vorzugsweise im Datenspeicher gespeichert werden. Dies wiederum erlaubt eine besonders präzise Bestimmung des ersten Sensorabstands.

Eine vorteilhafte Ausgestaltung des Systems zeichnet sich dadurch aus, dass der erste Sensor und die zweite Impulseinspeiseeinheit als eine gemeinsame, erste Wandlereinheit ausgebildet sind. Die erste Wandlereinheit kann ausgebildet sein, um an einem Ende der Kabelstrecke angeordnet und/oder befestigt zu werden. Eine weitere Ausgestaltung des Systems zeichnet sich dadurch aus, dass der zweite Sensor und die erste Impulseinspeiseeinheit als eine gemeinsame, zweite Wandlereinheit ausgebildet sein. Die zweite Wandlereinheit kann ausgebildet sein, an einem weiteren Ende der Kabelstrecke angeordnet und/oder befestigt zu werden. Somit können die erste und zweite Wandlereinheit an gegenüberliegenden Enden der elektrischen Kabelstrecke angeordnet und/oder befestigt werden.

Eine weitere vorteilhafte Ausgestaltung des Systems zeichnet sich dadurch aus, dass die Prozessoreinheit konfiguriert ist, die erste und/oder zweite Impulseinspeiseeinheit periodisch zum Einspeisen von Referenzimpulsen und nach jedem Einspeisen der Referenzimpulse zum Anpassen der Parameter des Kabelmodells ausgebildet ist.

Die periodische Einspeisung von Referenzimpulsen, vorzugsweise die periodische Einspeisung von ersten Referenzimpulsen und/oder die periodische Einspeisung von zweiten Referenzimpulsen, erlaubt es, dass das Kabelmodell periodisch aktualisiert wird. Damit kann auch eine periodische Aktualisierung der ersten Kurvenmenge und/oder der zweiten Kurvenmenge erfolgen. Entsprechendes gilt für die zugehörigen Abstände. Hierzu kann die Prozessoreinheit entsprechend konfiguriert sein. Durch die periodische Aktualisierung des Kabelmodells und/oder der Kurvenmenge bzw. Kurvenmengen ist eine besonders präzise und jeweils aktuelle Erfassung des ersten Sensorabstands möglich.

Eine weitere vorteilhafte Ausgestaltung des Systems zeichnet sich dadurch aus, dass der erste Sensor zur periodischen Erfassung elektrischer Signale der Kabelstrecke ausgebildet ist. Die Prozessoreinheit ist außerdem vorzugsweise dazu konfiguriert, bei jedem Fall, wenn das vom ersten Sensor erfasste elektrische Signal ein erstes Entladungssignal bildet, die zugehörige erste Entladungskurve zu bestimmen und den ersten Sensorabstand des ersten Sensors zu der jeweiligen Teilentladung basierend auf der ersten Entladungskurve zu bestimmen.

Es kann deshalb bevorzugt vorgesehen sein, dass der erste Sensorabstand ereignisgesteuert ermittelt wird, nämlich immer dann, wenn das vom ersten Sensor erfasste elektrische Signal ein erstes Entladungssignal bildet. Dadurch kann der erste Sensorabstand bei jeder erfassten Teilentladung an der Kabelstrecke bestimmt werden.

Eine weitere vorteilhafte Ausgestaltung des Systems zeichnet sich dadurch aus, dass der zweite Sensor zur periodischen Erfassung elektrischer Signale der Kabelstrecke ausgebildet ist. Die Prozessoreinheit ist außerdem vorzugsweise dazu konfiguriert, bei jedem Fall, wenn das vom zweiten Sensor erfasste elektrische Signal ein zweites Entladungssignal bildet, die zugehörige zweite Entladungskurve zu bestimmen und den ersten Sensorabstand der jeweiligen Teilentladung zum ersten Sensor basierend auf dem vorbestimmten Sensorabstand, dem der ersten Entladungskurve zugehörigen Abstand und dem der zweiten Entladungskurve zugehörigen Abstand zu bestimmen. Zur Bestimmung des ersten Sensorabstands wurde bereits zuvor festgestellt, wenn das System den ersten und zweiten Sensor aufweist, dass der erste Sensorabstand besonders präzise bestimmt werden kann, wenn der zu der ersten Entladungskurve zugehörige Abstand, der zu der zweiten Entladungskurve zugehörige Abstand und der vorbestimmte Sensorabstand zwischen den beiden Sensoren verwendet wird. Dieser erste Sensorabstand kann deshalb ebenfalls ereignisgesteuert bestimmt werden, nämlich in jedem Fall, wenn die vom ersten und zweiten Sensor erfassten elektrischen Signale zugehörige Entladungssignale bilden.

Eine weitere vorteilhafte Ausgestaltung des Systems zeichnet sich dadurch aus, dass die Prozessoreinheit konfiguriert ist, eine Häufigkeit von mehreren tatsächlichen Teilentladungen in dem gleichen Abstand zum ersten Sensor zu ermitteln, und wobei das Ausgangssignal außerdem die Häufigkeit repräsentiert.

Indem die Prozessoreinheit konfiguriert ist, die erste und/oder zweite Entladungskurve zu bestimmen, ist es möglich, dass auch schwache Teilentladungen erfasst und berücksichtigt werden und hierzu jeweils ein erster Sensorabstand ermittelt werden kann. Treten mehrere schwache Teilentladungen an dem gleichen Teilentladungsort, und somit mit dem gleichen ersten Sensorabstand zum ersten Sensor auf, kann dies in der Praxis dazu führen, dass diese mehreren, schwachen Teilentladungen einen ähnlichen nachteiligen Einfluss auf die Kabelstrecke verursachen wie eine einzelne, besonders starke Teilentladung. Die Häufigkeit von mehreren, tatsächlichen Teilentladungen, die jeweils im gleichen ersten Sensorabstand zum ersten Sensor an der Kabelstrecke auftreten, ist deshalb in der Praxis eine besonders relevante Information. Die Übertragung der Häufigkeit derartiger Teilentladungen mittels des Ausgangssignals bietet deshalb vorteilhaft die Möglichkeit, den Zustand der Kabelstrecke präzise zu überwachen.

Eine weitere vorteilhafte Ausgestaltung des Systems zeichnet sich dadurch aus, dass die Prozessoreinheit konfiguriert ist, wenigstens eine Kenngröße von mehreren tatsächlichen Teilentladungen in dem gleichen Abstand zum ersten Sensor zu ermitteln, und wobei das Ausgangssignal außerdem die ermittelte Kenngröße repräsentiert.

Die Kenngröße kann eine Eigenschaft der Teilentladungen repräsentieren. So kann die Kenngröße beispielsweise die Energie der Teilentladungen repräsentieren. Die Energie der Teilentladungen kann jedoch nur eine von vielen Informationen sein, die aus der spektralen Zusammensetzung der Teilentladungen ermittelt werden kann. Die Prozessoreinheit kann dazu ausgebildet sein, eine Quelle-Filter Separierung auszuführen, um die Kenngröße zu ermitteln.

Eine weitere vorteilhafte Ausgestaltung des Systems zeichnet sich dadurch aus, dass die Prozessoreinheit konfiguriert ist, ein Warnsignal zu erzeugen, wenn die Häufigkeit der Teilentladungen größer als eine vorbestimmte Schwellwerthäufigkeit ist und/oder wenn die ermittelte Kenngröße der Teilentladungen größer als eine vorbestimmte Schwellwertkenngröße ist, und wobei die Signalschnittstelle zum Übertragen des Warnsignals ausgebildet ist.

Zuvor wurde bereits erläutert, dass die Häufigkeit von Teilentladungen, die in dem gleichen ersten Sensorabstand zum ersten Sensor auftreten, zu einer Schädigung der Kabelstrecke führen können. Die Häufigkeit dieser Teilentladungen kann dabei ein Maß für die Schädigung sein. Es ist deshalb von Vorteil, dass ein Warnsignal erzeugt wird, wenn die Häufigkeit größer als die vorbestimmte Schwellwerthäufigkeit ist. Die Schwellwerthäufigkeit kann so vorbestimmt sein, dass das Warnsignal rechtzeitig erzeugt wird, bevor die Schädigung der Kabelstrecke ein zu großes Ausmaß annimmt. In analoger Weise kann die Kenngröße Berücksichtigung finden, wenn die Kenngröße nämlich größer als eine vorbestimmte Schwellwertkenngröße ist. Auch in diesem Fall besteht die Gefahr einer Schädigung der Kabelstrecke, sodass ein entsprechendes Warnsignal zu erzeugen ist.

Eine weitere vorteilhafte Ausgestaltung des Systems zeichnet sich dadurch aus, dass die Prozessoreinheit konfiguriert ist, einen Alterungszustand der Kabelstrecke basierend auf der Häufigkeit der Teilentladungen und/oder der wenigstens einen ermittelten Kenngröße der Teilentladungen und/oder der angepassten Parameter zu ermitteln, wobei das Ausgangssignal außerdem den Alterungszustand repräsentiert.

In Abhängigkeit der Anzahl und/oder der Größe von Schädigungen der Kabelstrecke kann der Alterungszustand der Kabelstrecke bestimmt sein. Zur Bestimmung kann die Prozessoreinheit entsprechend konfiguriert sein. Besteht eine große Häufigkeit von Teilentladungen, deutet dies auf einen zunehmenden Alterungszustand hin. Entsprechendes kann basierend auf der Kenngröße ermittelt werden. Die Prozessoreinheit kann auch konfiguriert sein, die Parameter des Kabelmodells basierend auf dem Alterungszustand anzupassen.

Eine weitere vorteilhafte Ausgestaltung des Systems zeichnet sich dadurch aus, dass die Kabelstrecke mehrere Kabelsegmente aufweist, die entlang der Kabelstrecke hintereinander angeordnet sind, wobei stirnseitig gegenüberliegende Enden von Kabelsegmenten miteinander verbunden sind, um Koppelstellen zu bilden. Jedem Kabelsegment ist ein erster Sensor und eine erste Kurvenmenge für den jeweiligen ersten Sensor zugeordnet, so dass das System mehrere erste Sensoren aufweist und mehrere erste Kurvenmengen von dem Datenspeicher gespeichert sind. Die Prozessoreinheit ist vorzugsweise konfiguriert, das Kabelsegment mit der Teilentladung als identifiziertes Kabelsegment basierend auf den ersten Sensorabständen zu ermitteln. Die Signalschnittstelle ist vorzugsweise ausgebildet, das Ausgangssignal bereitzustellen, das das identifizierte Kabelsegment indiziert sowie den ersten Sensorabstand des ersten Sensors des identifizierten Kabelelements von der Teilentladung repräsentiert.

In der Praxis kann es vorkommen, dass eine Teilentladung in einer der Kabelsegmente auftritt. Das Kabelsegment, in dem die Teilentladung auftritt, ist jedoch mit den anderen Kabelsegmenten gekoppelt. Von der Teilentladung wird deshalb ein elektrischer Impuls verursacht, der sich über alle Kabelsegmente ausbreitet und deshalb auch an allen ersten Sensoren erfasst wird. Um zu verhindern, dass versehentlich angenommen wird, dass in jedem der Kabelsegmente eine Teilentladung stattgefunden hat, wird das Kabelsegment mit der tatsächlichen Teilentladung als identifiziertes Kabelsegment basierend auf den ersten Sensorabständen mittels der Prozessoreinheit ermittelt. Die übrigen, ersten Sensorabstände werden verworfen. Außerdem ist es bevorzugt vorgesehen, dass das Ausgangssignal, das von der Signalschnittstelle bereitgestellt wird, das identifizierte Kabelsegment indiziert sowie den ersten Sensorabstand zum ersten Sensor des identifizierten Kabelsegments repräsentiert. Dadurch kann eine besonders präzise und eindeutige Bestimmung des ersten Sensorabstands und somit auch eine eindeutige Bestimmung des Teilentladungsorts entlang der gesamten Kabelstrecke bestimmt werden. Die Prozessoreinheit kann hierzu entsprechend konfiguriert sein.

Gemäß einem zweiten Aspekt der Erfindung wird die eingangs genannte Aufgabe gelöst durch ein Übertragungssystem mit den Merkmalen des Anspruchs 15. Vorgesehen ist also ein Übertragungssystem zur Übertragung von elektrischer Energie, wobei das Übertragungssystem eine Kabelstrecke und ein System aufweist. Das System ist dabei das System gemäß dem ersten Aspekt der Erfindung und/oder einer der zugehörigen, vorteilhaften Ausgestaltungen. Bezüglich des Systems wird auf die vorangegangenen Erläuterungen, bevorzugten Merkmale, technischen Effekte und/oder Vorteile in analoger Weise Bezug genommen, wie sie bereits zu dem ersten Aspekt der Erfindung oder einer der zugehörigen, vorteilhaften Ausgestaltungen erläutert worden ist.

Gemäß einem dritten Aspekt der Erfindung wird die eingangs genannte Aufgabe gelöst durch ein Verfahren mit den Merkmalen des Anspruchs 16. Vorgesehen ist also ein Verfahren zum Betrieb eines Systems für eine elektrische Kabelstrecke zur Übertragung von elektrischer Energie, wobei das System einen ersten Sensor zur Erfassung elektrischer Signale der Kabelstrecke, eine Prozessoreinheit, einen Datenspeicher und eine Signalschnittstelle aufweist. Der Datenspeicher hat eine erste Kurvenmenge aus mehreren ersten Kurven mit jeweils einem zugehörigen Abstand zum ersten Sensor gespeichert. Jede erste Kurve repräsentiert eine mittels eines Kabelmodells der Kabelstrecke vorbestimmte Impulsantwort eines elektrischen Impulses durch eine modellierte Teilentladung in dem für die jeweilige erste Kurve zugehörigen Abstand zum ersten Sensor an der Kabelstrecke. Darüber hinaus weist das Verfahren folgende Schritte a) bis e) auf: In Schritt a) wird elektrische Energie mittels der Kabelstrecke übertragen. In Schritt b) wird ein elektrisches Signal mittels des ersten Sensors erfasst, das als erstes Entladungssignal bezeichnet wird und durch eine tatsächliche Teilentladung an der Kabelstrecke verursacht ist. In Schritt c) wird ein erstes Messsignal von dem ersten Sensor an die Prozessoreinheit direkt oder indirekt übertragen, das das erste Entladungssignal repräsentiert. In Schritt d) wird eine erste Kurve der ersten Kurvenmenge, basierend auf dem ersten Messsignal und mittels der Prozessoreinheit, als die erste Entladungskurve bestimmt, die unter den ersten Kurven der ersten Kurvenmenge am Besten mit dem ersten Entladungssignal korreliert. In Schritt e) wird ein erster Sensorabstand der tatsächlichen Teilentladung zum ersten Sensor basierend auf dem zur ersten Entladungskurve zugehörigen Abstand mittels der Prozessoreinheit bestimmt.

Die Schritte des Verfahrens korrespondieren zu den Merkmalen des Systems gemäß dem ersten Aspekt der Erfindung. Für das Verfahren gemäß dem dritten Aspekt der Erfindung wird deshalb auf die vorteilhaften Erläuterungen, bevorzugten Merkmale, technischen Effekte und/oder Vorteile in analoger Weise Bezug genommen, wie sie für das System gemäß dem ersten Aspekt der Erfindung bereits erläutert worden sind. Auf eine Wiederholung wird deshalb verzichtet.

Außerdem wird zu den im Folgenden wiedergegebenen, vorteilhaften Ausgestaltungen des Verfahrens auf die Erläuterungen, bevorzugten Merkmale, technischen Effekte und Vorteile in analoger Weise Bezug genommen, wie sie für die entsprechenden, vorteilhaften Ausgestaltungen des Systems bereits erläutert worden sind. Auch hier wird auf eine analoge Wiederholung verzichtet.

Eine vorteilhafte Ausgestaltung des Verfahrens zeichnet sich dadurch aus, dass das System einen zweiten Sensor zur Erfassung elektrischer Signale der Kabelstrecke aufweist, wobei der Datenspeicher eine zweite Kurvenmenge aus mehreren zweiten Kurven mit jeweils einem zugehörigen Abstand zum zweiten Sensor gespeichert hat. Jede zweite Kurve repräsentiert eine mittels des Kabelmodells der Kabelstrecke vorbestimmte Impulsantwort eines elektrischen Impulses durch eine modellierte Teilentladung in dem für die jeweilige zweite Kurve zugehörigen Abstand zum zweiten Sensor an der Kabelstrecke. Der erste Sensor und der zweite Sensor sind in einem vorbestimmten Sensorabstand voneinander an der Kabelstrecke angeordnet. Darüber hinaus weist das Verfahren die weiteren, folgenden Schritte d.1) bis d.3) auf: In Schritt d.1) wird ein elektrisches Signal mittels des zweiten Sensors erfasst, das als zweites Entladungssignal bezeichnet wird und durch die gleiche, tatsächliche Teilentladung an der Kabelstrecke verursacht ist. In Schritt d.2) wird ein zweites Messsignal von dem zweiten Sensor an die Prozessoreinheit direkt oder indirekt übertragen, das das zweite Entladungssignal repräsentiert. In Schritt d.3) wird eine zweite Kurve der zweiten Kurvenmenge, basierend auf dem zweiten Messsignal und mittels der Prozessoreinheit, als die zweite Entladungskurve bestimmt, die unter den zweiten Kurven der zweiten Kurvenmenge am Besten mit dem zweiten Entladungssignal korreliert. Der erste Sensorabstand wird in Schritt e) zusätzlich basierend auf dem zur zweiten Entladungskurve zugehörigen Abstand mittels der Prozessoreinheit bestimmt.

Eine weitere vorteilhafte Ausgestaltung des Verfahrens zeichnet sich dadurch aus, dass das System eine erste Impulseinspeiseeinheit zur Einspeisung mindestens eines ersten, elektrischen Impulses in die Kabelstrecke aufweist. Die Prozessoreinheit ist konfiguriert, Parameter des Kabelmodells zu verändern, das ein Übertragungsverhalten von elektrischen Impulsen über die Kabelstrecke repräsentiert. Die erste Impulseinspeiseeinheit ist beabstandet von dem ersten Sensor angeordnet. Ferner weist das Verfahren die weiteren, folgenden Schritte f) bis i) auf: In Schritt f) wird die erste Impulseinspeiseeinheit mittels der Prozessoreinheit gesteuert, so dass als erste Referenzimpulse bezeichnete, elektrische Impulse mittels der ersten Impulseinspeiseeinheit in die Kabelstrecke eingespeist werden. In Schritt g) werden als erste Referenzsignale bezeichnete, elektrische Signale mittels des ersten Sensors erfasst, die jeweils durch einen der ersten Referenzimpulse verursacht wurden. In Schritt h) werden erste Testsignale direkt oder indirekt von dem ersten Sensor an die Prozessoreinheit übertragen, die jeweils einen der ersten Referenzsignale repräsentieren. In Schritt i) werden die Parameter des Kabelmodells mittels der Prozessoreinheit und basierend auf dem mindestens einen ersten Testsignal angepasst, so dass das von dem Kabelmodell repräsentierte Übertragungsverhalten zu dem durch die ersten Referenzimpulse und die ersten Referenzsignale repräsentierten, tatsächlichen Übertragungsverhalten der Kabelstrecke entspricht.

Eine weitere vorteilhafte Ausgestaltung des Verfahrens zeichnet sich dadurch aus, dass das System eine zweite Impulseinspeiseeinheit zur Einspeisung mindestens eines zweiten, elektrischen Impulses in die Kabelstrecke aufweist, wobei die zweite Impulseinspeiseeinheit beabstandet von dem zweiten Sensor angeordnet ist. Ferner weist das Verfahren die weiteren, folgenden Schritte j) bis l) auf: In Schritt j) wird die zweite Impulseinspeiseeinheit mittels der Prozessoreinheit gesteuert, so dass als zweite Referenzimpulse bezeichnete, elektrische Impulse mittels der zweiten Impulseinspeiseeinheit in die Kabelstrecke eingespeist werden. In Schritt k) wird ein elektrisches Signal mittels des zweiten Sensors erfasst, das als zweites Referenzsignal bezeichnet wird und durch die zweiten Referenzimpulse verursacht ist. In Schritt l) wird ein zweites Testsignal direkt oder indirekt von dem zweiten Sensor an die Prozessoreinheit übertragen, das das zweite Referenzsignal repräsentiert. Darüber hinaus werden die Parameter des Kabelmodells in Schritt j) mittels der Prozessoreinheit basierend auf dem ersten Testsignal und dem zweiten Testsignal derart angepasst, so dass das von dem Kabelmodell repräsentierte Übertragungsverhalten zu dem durch die ersten Referenzimpulse und die zweiten Referenzsignale und/oder durch die zweiten Referenzimpulse und zweiten Referenzsignale repräsentierten, tatsächlichen Übertragungsverhalten der Kabelstrecke entspricht.

Eine weitere vorteilhafte Ausgestaltung des Verfahrens zeichnet sich dadurch aus, dass das Verfahren den weiteren, folgenden Schritt m) aufweist: In Schritt m) wird ein Ausgangssignal mittels der Signalschnittstelle übertragen, das den ersten Sensorabstand repräsentiert.

Eine weitere vorteilhafte Ausgestaltung des Verfahrens zeichnet sich dadurch aus, dass die Gruppe der Verfahrensschritte a) bis e) einmalig oder wiederholt ausgeführt werden.

Eine weitere vorteilhafte Ausgestaltung des Verfahrens zeichnet sich dadurch aus, dass die Schritte g) bis j) oder die Schritte g) bis m) einmalig, periodisch, nach oder vor jedem Ausführen der Gruppe der Verfahrensschritte a) bis e) ausgeführt werden.

Eine weitere vorteilhafte Ausgestaltung des Verfahrens zeichnet sich dadurch aus, dass die erste und/oder zweite Kurvenmenge mit dem durch die angepassten Parameter aktualisierten Kabelmodell mittels der Prozessoreinheit berechnet und in dem Datenspeicher gespeichert wird, vorzugsweise nach jeder Anpassung der Parameter des Kabelmodells.

Weitere Merkmale, Vorteile und Anwendungsmöglichkeiten der vorliegenden Erfindung ergeben sich aus der nachfolgenden Beschreibung der Ausführungsbeispiele und den Figuren. In den Figuren stehen weiterhin gleiche Bezugszeichen für gleiche oder ähnliche Objekte.
- Fig. 1: zeigt eine erste vorteilhafte Ausgestaltung des Systems in einer schematischen Darstellung.
- Fig. 2: zeigt mehrere Kurven einer gemeinsamen Kurvenmenge.
- Fig. 3: zeigt eine weitere vorteilhafte Ausgestaltung des Systems in einer schematischen Darstellung.
- Fig. 4: zeigt eine weitere, vorteilhafte Ausgestaltung des Systems in einer schematischen Darstellung.
- Fig. 5: zeigt eine weitere vorteilhafte Ausgestaltung des Systems in einer schematischen Darstellung.
- Fig. 6 bis 8: zeigen jeweils vorteilhafte Ablaufdiagramme für das Verfahren.

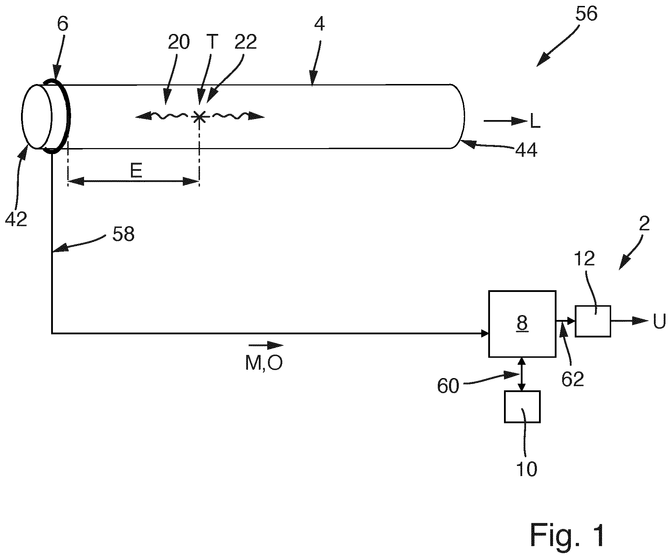

In der Figur 1 ist eine vorteilhafte Ausgestaltung des Systems 2 schematisch dargestellt. Das System 2 umfasst einen ersten Sensor 6, eine Prozessoreinheit 8, einen Datenspeicher 10 und eine Signalschnittstelle 12. Der erste Sensor 6 ist zur Erfassung eines elektrischen Signals der Kabelstrecke 4 ausgebildet. Deshalb dient das System 2 auch für eine elektrische Kabelstrecke 4, die zur Übertragung von elektrischer Energie dient.

Grundsätzlich kann der erste Sensor 6 als einzelner Sensor 6 oder als ein integraler Teil einer weiteren Vorrichtung ausgebildet sein. So werden beispielsweise in der Praxis oftmals Hochfrequenzwandler an den Enden der Kabelstrecke befestigt, wobei der erste Sensor 6 Teil eines derartigen Hochfrequenzwandlers sein kann.

Die elektrische Kabelstrecke 4 kann auch als elektrisches Kabel ausgebildet und/oder bezeichnet sein. Die elektrische Kabelstrecke 4 weist oftmals einen elektrisch leitfähigen Kern, beispielsweise aus Kupfer, und eine Isolierung auf, die den Kern ummantelt. Wird ein elektrisches Signal über den leitfähigen Kern übertragen, so kann der erste Sensor 6 beispielsweise zur kontaktlosen Erfassung des elektrischen Signals ausgebildet sein. Es ist jedoch alternativ auch möglich, dass der Sensor 6 einen elektrischen Kontakt zu dem elektrisch leitfähigen Kern der Kabelstrecke 4 hat, sodass der erste Sensor 6 über diesen elektrischen Kontakt zur Erfassung elektrischer Signale der Kabelstrecke 4 ausgebildet ist.

Der erste Sensor 6 ist vorzugsweise über eine Signalverbindung 58 mit der Prozessoreinheit 8 gekoppelt. Die Prozessoreinheit 8 kann wiederum über eine weitere Signalverbindung 60 mit dem Datenspeicher 10 gekoppelt sein, um Daten aus dem Datenspeicher 10 auszulesen oder um Daten auf dem Datenspeicher 10 zu speichern. Darüber hinaus ist es bevorzugt vorgesehen, dass die Prozessoreinheit 8 über eine weitere Signalverbindung 62 mit der Signalschnittstelle 12 verbunden ist. Die Signalschnittstelle 12 dient zum Übertragen eines Ausgangssignals U. Die Prozessoreinheit 8 kann die Signalschnittstelle 12 beispielsweise derart über die weitere Signalleitung 62 steuern, um das Ausgangssignal U zu senden. Die Signalschnittstelle 12 kann einen integralen Teil der Prozessoreinheit 8 bilden. Somit können die Prozessoreinheit 8 und die Signalschnittstelle 12 eine gemeinsame Einheit bilden. Außerdem ist es möglich, dass dieser gemeinsamen Einheit der Datenspeicher 10 zugeordnet ist. Mit anderen Worten kann eine gemeinsame Einheit vorgesehen sein, die die Prozessoreinheit 8, den Datenspeicher 10 und die Signalschnittstelle 12 umfasst.

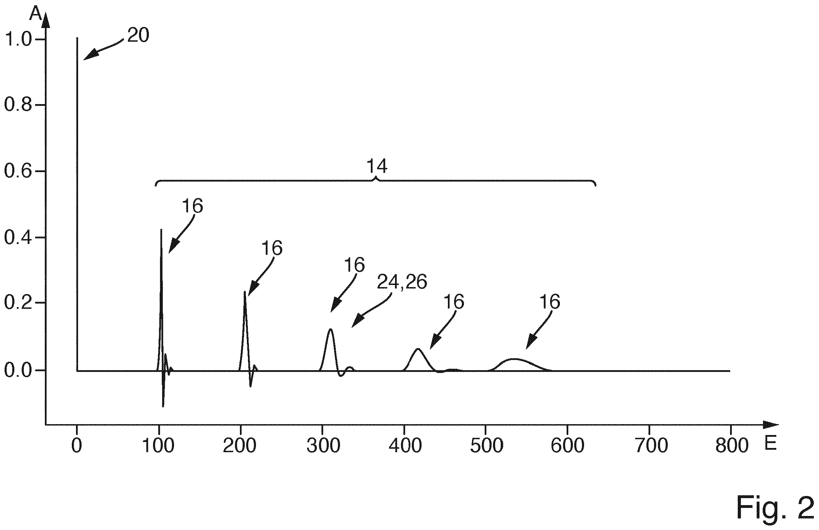

Bei der Übertragung von elektrischer Energie mit einer Kabelstrecke 4 kann es zu einer Teilentladung 22 kommen, insbesondere wenn die elektrische Energie mit einer besonders hohen elektrischen Spannung übertragen wird. Die Teilentladung 22 kann an einem Teilentladungsort T stattfinden. Durch die Teilentladung 22 wird ein Impuls 20 verursacht, der sich in Axialrichtung L der Kabelstrecke 4 in gegenüberliegende Richtungen erstreckt. Ist der Teilentladungsort T in einem ersten Sensorabstand E zu dem ersten Sensor 6 entfernt, so bedarf es einer gewissen Laufzeit, bis der Impuls 20 von dem Teilentladungsort T zu dem ersten Sensor 6 gelangt. Die Verwendung zur Laufzeit zur Bestimmung des Teilentladungsorts T hat sich in der Praxis jedoch als fehleranfällig erwiesen. Der von der Teilentladung 22 verursachte Impuls 20 ist rein beispielhaft in der Figur 2 dargestellt. Dabei ist die Amplitude A des Impulses 20 auf eins nummeriert. Durch die physikalischen Eigenschaften der Kabelstrecke 4 unterliegt der Impuls 20 einer ortsabhängigen und/oder frequenzabhängigen Dämpfung und/oder Dispersion. In Abhängigkeit von dem ersten Sensorabstand E zwischen dem Teilentladungsort T und dem ersten Sensor 6 verändert sich die Signalform derart, wie es in Figur 2 schematisch dargestellt ist.

Wird rein beispielhaft angenommen, dass die Länge der Kabelstrecke 4 etwa 800 m beträgt, so ist die Veränderung des Impulses 20 in Abhängigkeit der zurückgelegten Strecke bzw. in Abhängigkeit von dem ersten Sensorabstand E in der Figur 2 dargestellt. Tritt die Teilentladung T beispielsweise in einem ersten Sensorabstand E von 100 m zu dem ersten Sensor 6 auf, so wird der erste Sensor 6 ein elektrisches Signal erfassen können, das zumindest in der Form der Kurve 16 entspricht, die in der Figur 2 bei dem ersten Sensorabstand E von 100 m aufgetragen ist. Tritt die Teilentladung 22 an einem Teilentladungsort T auf, der weiter entfernt ist, beispielsweise 200 m von dem ersten Sensor 6 entfernt ist, so beträgt der erste Sensorabstand E 200 m. In diesem Fall wird der Sensor 6 ein elektrisches Signal erfassen können, das zu der Kurve 16 bei dem ersten Sensorabstand E von 200 m korrespondiert. Mit anderen Worten wird das in diesem Fall erfasste, elektrische Signal bis auf einen proportionalen Faktor die Form aufweisen, die die Kurve 16 bei dem ersten Sensorabstand E von 200 m hat. Die weiteren Kurven 16 aus Figur 2 resultieren bei Teilentladungen 22 mit einem ersten Sensorabstand E von 300 m, 400 m oder 500 m.

Aus der Figur 2 ist ersichtlich, dass sich die Kurven 16 in Abhängigkeit von dem ersten Sensorabstand E in ihrem Frequenzgang als auch in ihrem Amplitudengang unterscheiden. Deshalb kann der erste Sensorabstand E auch unabhängig von der Laufzeit des ersten Impulses 20 anhand der Kurvenform des von dem ersten Sensor 6 gemessenen Signals bestimmt werden. Um dies zu ermöglichen, ist von dem Datenspeicher 10 eine erste Kurvenmenge 14 aus mehreren ersten Kurven 16 mit jeweils einem zugehörigen Abstand zu dem ersten Sensor 6 gespeichert, wobei jede erste Kurve 16 eine mittels eines Kabelmodells der Kabelstrecke 4 vorbestimmte Impulsantwort eines elektrischen Impulses 20 durch eine modellierte Teilentladung 22 in einem für die jeweilige erste Kurve 16 zugehörigen Abstand zum ersten Sensor 6 an der Kabelstrecke 4 repräsentiert.

Die Verwendung eines Kabelmodells der Kabelstrecke 4 bietet den Vorteil, dass die Kabelstrecke 4 nicht durch Teilentladungen 22 teilweise zerstört werden muss, um an die Information über die ersten Kurven 16 zu gelangen. Vielmehr kann mit dem Kabelmodell ein Impuls 20 an einer beliebigen Stelle an der modellierten Kabelstrecke 4 hervorgerufen werden, und mit dem gleichen Kabelmodell die erste Kurve 16 ermittelt werden, die in dem jeweiligen Abstand des auf die modellierte Kabelstrecke 4 einwirkenden Impulses zu dem Ort des ersten Sensors 6 gemessen werden würde. Durch die Variation des Abstands zu dem Ort des Sensors 6 können also eine Vielzahl von ersten Kurven 16 mittels des Kabelmodells vorbestimmt werden. Dazu kann die Prozessoreinheit 8 konfiguriert sein. Diese ersten Kurven 16 bilden zusammen die erste Kurvenmenge 14. Diese Kurvenmenge 14 ist in dem Datenspeicher 10 gespeichert. Dabei können in dem Datenspeicher 10 tatsächlich Daten gespeichert sein, die die erste Kurvenmenge 14 bzw. die ersten Kurven 16 repräsentieren. Für die zugehörigen Abstände gilt analoges.

Die ersten Kurven 16 der ersten Kurvenmenge 14 können sodann mit einem elektrischen Signal des ersten Sensors 6 verglichen werden, der an der tatsächlichen Kabelstrecke 4 zur Erfassung der elektrischen Signale angeordnet ist. Dabei kann diejenige Kurve 16 bestimmt werden, die zu dem tatsächlich mittels des ersten Sensors 6 erfassten, elektrischen Signals am Besten korreliert bzw. übereinstimmt. In dem Datenspeicher 10 ist außerdem zu jeder ersten Kurve 16 ein zugehöriger Abstand gespeichert. Wurde also eine der Kurven 16 als die erste Entladungskurve 26 bestimmt, die unter den ersten Kurven 16 der ersten Kurvenmenge 14 am Besten mit dem tatsächlich von dem Sensor 6 erfassten Entladungssignal 24 korreliert, so kann der zu der ersten Entladungskurve 26 zugehörige Abstand, beispielsweise der erste Sensorabstand E von 300 m, mittels der im Datenspeicher 10 abgespeicherten ersten Kurven 16 und zugehörigen Abstände bestimmt werden.

Für das System 2 ist es deshalb vorgesehen, dass der erste Sensor 6 zur Erfassung eines elektrischen Signals ausgebildet ist, das als erstes Entladungssignal 24 bezeichnet wird und durch eine tatsächliche Teilentladung 22 an der Kabelstrecke 4 verursacht ist. Dieses erste Entladungssignal 24 ist jedoch für gewöhnlich ein analoges Signal. Der erste Sensor 6 ist deshalb vorzugsweise zur Digitalisierung des ersten Entladungssignals 24 ausgebildet, um basierend hierauf ein erstes Messsignal M zu bestimmen, das das erste Entladungssignal 24 repräsentiert. Der erste Sensor 6 kann sodann das erste Messsignal M beispielsweise über die Signalverbindung 58 zu der Prozessoreinheit 8 übertragen. Die Signalverbindung kann als eine leitungsgebundene Signalverbindung 58 oder als eine schnurlose Signalverbindung 58 ausgebildet sein. Es ist jedoch auch möglich, dass zwischen dem ersten Sensor 6 und der Prozessoreinheit 8 eine optische Signalverbindung besteht, über die das erste Messsignal M von dem ersten Sensor 6 an die Prozessoreinheit 8 übertragbar ist.

Die Prozessoreinheit 8 ist konfiguriert, basierend auf dem ersten Messsignal M eine der ersten Kurven 16 der ersten Kurvenmenge 14 als die erste Entladungskurve 26 zu bestimmen, die unter den ersten Kurven 16 der ersten Kurvenmenge 14 am Besten mit dem ersten Entladungssignal 24 übereinstimmt. Welche der ersten Kurven 16 am Besten mit dem ersten Entladungssignal 24 übereinstimmt, kann anhand der Kreuzkorrelation zwischen dem ersten Entladungssignal 24 und der jeweiligen ersten Kurve 16 bestimmt werden. Die erste Kurve 16, die den größten Korrelationswert hervorruft, kann als am Besten mit dem ersten Entladungssignal 24 übereinstimmend verstanden werden. Die entsprechende erste Kurve 16 bildet sodann die erste Entladungskurve 26. Zu dieser ersten Entladungskurve 26 ist ein zugehöriger Abstand in dem Datenspeicher 10 abgespeichert. Die Prozessoreinheit 8 ist über die Signalverbindung 60 mit dem Datenspeicher 10 gekoppelt, sodass die Prozessoreinheit 8 den entsprechenden Abstand zu der ersten Entladungskurve 26 aus dem Datenspeicher 10 auslesen kann. Die Prozessoreinheit 8 ist deshalb dazu konfiguriert, einen ersten Sensorabstand E der tatsächlichen Teilentladung 22 zum ersten Sensor 6 basierend auf dem zur ersten Entladungskurve 26 zugehörigen Abstand zu bestimmen. Im einfachsten Fall entspricht der erste Sensorabstand E dem zu der ersten Entladungskurve 26 zugehörigen Abstand, der in dem Datenspeicher 10 gespeichert ist. In dem in Figur 1 und Figur 2 gezeigten Fall ist der zu der ersten Entladungskurve 26 im Datenspeicher 10 gespeicherte Abstand 300 m. Deshalb kann in diesem Fall der erste Sensorabstand E als 300 m bestimmt werden.

Um diese Information über den ersten Sensorabstand E von 300 m zur Verfügung zu stellen, weist das System 2 die Signalschnittstelle 12 auf, die ausgestaltet ist, ein Ausgangssignal U zu übertragen, das den ersten Sensorabstand E repräsentiert. Dadurch kann die Information über den ersten Sensorabstand E für weitere Bauteile, Vorrichtungen und/oder Module des Systems 2 verfügbar gemacht werden.

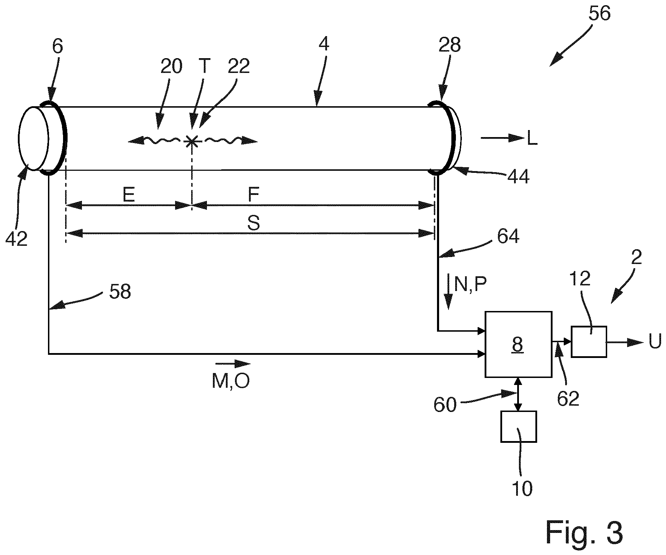

In der Figur 3 ist eine weitere vorteilhafte Ausgestaltung des Systems 2 schematisch dargestellt. Bezüglich des Systems 2 aus der Figur 3 wird auf die vorangegangenen Erläuterungen zu dem System aus Figur 1 in analoger Weise Bezug genommen. Jedoch weist das System 2 aus Figur 3 einen weiteren Sensor 28, nämlich den zweiten Sensor 28 auf. Der erste und zweite Sensor 6, 28 können an gegenüberliegenden Enden 42, 44 der Kabelstrecke 4 angeordnet und/oder befestigt sein. Der zweite Sensor 28 ist vorzugsweise analog zu dem ersten Sensor 6 ausgebildet. Bezüglich des zweiten Sensors 28 wird deshalb auf die vorteilhaften Erläuterungen, bevorzugten Merkmale, technischen Effekte und/oder Vorteile Bezug genommen, wie sie zuvor für den ersten Sensor 6 bereits erläutert worden sind.

Der zweite Sensor 28 ist vorzugsweise über eine weitere Signalverbindung 64 mit der Prozessoreinheit 8 gekoppelt, so dass ein zweites Messsignal N von dem zweiten Sensor 28 an die Prozessoreinheit 8 übertragbar ist.

Findet eine Teilentladung 22 an der Kabelstrecke 4 statt, so wird der daraus resultierende Impuls 20 als ein elektrisches Signal an dem ersten Sensor 6 als auch als ein weiteres elektrisches Signal an dem Sensor 28 erfasst. Die beiden erfassten elektrischen Signale sind jedoch unterschiedlich, da der erste Sensorabstand E nicht dem zweiten Sensorabstand F entspricht. Durch die unterschiedlichen Abstände E, F findet eine unterschiedliche Dämpfung und/oder Dispersion statt, so dass von dem ersten Sensor 6 ein erstes Entladungssignal 24 und von dem zweiten Sensor 28 ein zweites Entladungssignal erfasst werden. Ist die Gesamtlänge der Kabelstrecke 4 beispielsweise 800 m, so kann das erste Entladungssignal 24 über das erste Messsignal M an die Prozessoreinheit 8 übertragen werden. Die erste Prozessoreinheit 8 kann basierend auf dem ersten Entladungssignal 24 einen für die entsprechende erste Kurve 16 zugehörigen Abstand E von 300 m aus dem Datenspeicher 10 auslesen. Von dem Datenspeicher 10 kann eine weitere Kurvenmenge, nämlich eine zweite Kurvenmenge aus mehreren zweiten Kurven mit jeweils einem zugehörigen Abstand zum zweiten Sensor 28 gespeichert sein, wobei jede zweite Kurve eine mittels des Kabelmodells der Kabelstrecke 4 vorbestimmte Impulsantwort eines elektrischen Impulses durch eine modellierte Teilentladung in dem für die jeweilige zweite Kurve zugehörigen Abstand zum zweiten Sensor 28 an der Kabelstrecke 4 repräsentiert. Nachdem das zweite Messsignal N, dass das zweite Entladungssignal repräsentiert, an die Prozessoreinheit 8 übertragen ist, kann die Prozessoreinheit 8 eine der zweiten Kurven der zweiten Kurvenmenge als die zweite Entladungskurve bestimmen, die unter den zweiten Kurven, am Besten mit dem zweiten Entladungssignal übereinstimmt. Diese als zweite Entladungskurve bezeichnete zweite Kurve ist in dem Datenspeicher 10 zusammen mit einem zugehörigen Abstand gespeichert. Die Prozessoreinheit 8 kann deshalb den zugehörigen Abstand aus dem Datenspeicher 10 auslesen. Hierzu ist die Prozessoreinheit 8 vorzugsweise konfiguriert. Der entsprechende zweite Sensorabstand F kann beispielsweise 500 m sein. Sind die beiden Sensoren 6, 28 in einem Sensorabstand S von 800 m angeordnet, so sind die zuvor ermittelten Sensorabstände, nämlich der erste Sensorabstand E von 300 m und der zweite Sensorabstand F von 500 m, in Übereinstimmung mit dem Sensorabstand S zwischen den beiden Sensoren 6, 28 von 800 m. Die Prozessoreinheit 8 ist deshalb bevorzugt dazu konfiguriert, den ersten Sensorabstand E der tatsächlichen Teilentladung 22 zum ersten Sensor 6 basierend auf dem vorbestimmten Sensorabstand S (800 m), dem der ersten Entladungskurve 26 zugehörige Abstand (300 m) und dem der zweiten Entladungskurve zugehörige Abstand (500 m) zu bestimmen. In dem zuvor erläuterten Beispiel kann der erste Sensorabstand E als redundant bestimmt sein. Ergeben die Abstände E und F jedoch nicht durch Addition den Sensorabstand S, kann durch eine Mittelwertbildung von einerseits dem der ersten Entladungskurve zugehörigen Abstand und der Differenz aus dem Sensorabstand und dem der zweiten Entladungskurve zugehörigen Abstand bestimmt werden. Dadurch lässt sich der erste Sensorabstand E besonders präzise bestimmen. Durch den ersten Sensorabstand E und dem bekannten Ort für den ersten Sensor 6 ist gleichzeitig auch der Teilentladungsort T bekannt.

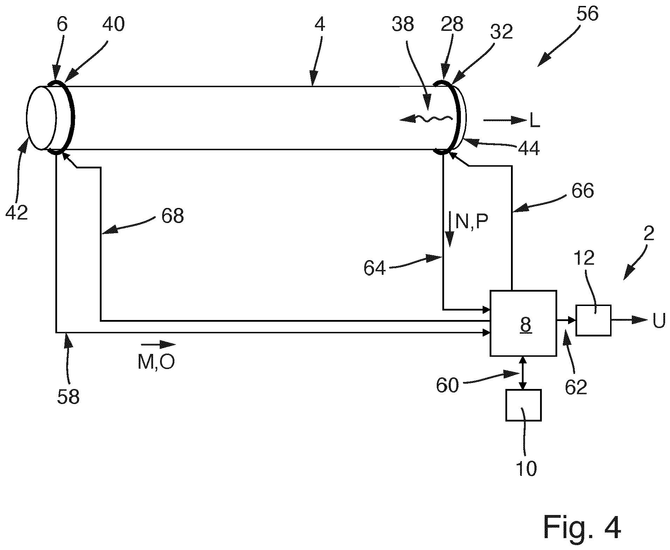

In der Figur 4 ist eine weitere vorteilhafte Ausgestaltung des Systems 2 dargestellt. Das System 2 entspricht dabei zumindest im Wesentlichen dem zu Figur 4 erläuterten System 2. Auf die entsprechenden Erläuterungen wird deshalb in analoger Weise Bezug genommen. Das System 2 aus Figur 4 weist darüber hinaus eine erste Impulseinspeiseeinheit 32 auf. Diese kann gemeinsam mit dem zweiten Sensor 28 ausgebildet sein. Die erste Impulseinspeiseeinheit 32 und der zweite Sensor 28 können also eine gemeinsame Einheit bilden.

Grundsätzlich können die Parameter des Kabelmodells vorbestimmt sein. So können die Parameter des Kabelmodells beispielsweise derart vorbestimmt sein, dass das Kabelmodell mit diesen Parametern erste und/oder zweite Kurvenmengen für eine Vielzahl von baugleichen Kabelstrecken 4 bestimmen kann. In der Praxis weisen die Kabelstrecken jedoch kleine bis größere Unterschiede zueinander auf. Der gleiche Parametersatz für ein Kabelmodell für eine Vielzahl von Kabelstrecken erlaubt deshalb oftmals nur eine suboptimale Modellierung. Um eine bessere Anpassung der Parameter an die jeweilige Kabelstrecke und damit eine bessere Modellierung der Kabelstrecke durch das Kabelmodell zu erreichen, ist es bevorzugt vorgesehen, dass die Parameter des Kabelmodells an die tatsächlichen Eigenschaften der jeweiligen Kabelstrecke 4 angepasst werden. Dies kann bei dem erstmaligen Betrieb der Kabelstrecke erfolgen. Es ist jedoch auch alternativ oder ergänzend möglich, dass die Parameter des Kabelmodells periodisch angepasst werden oder in Abhängigkeit von bestimmten Ereignissen angepasst werden. Durch die wiederholte Anpassung des Parameters des Kabelmodells während des Betriebs kann durch die angepassten Parameter des Kabelmodells eine bessere Modellierung der Kabelstrecke 4 gewährleistet werden, die in Betrieb möglicherweise auch gewissen Veränderungen unterliegt. Hat beispielsweise eine starke Teilentladung an der Kabelstrecke 4 stattgefunden, so dass sich dadurch die Dämpfungs- und/oder Dispersionseigenschaften der Kabelstrecke 4 verändern, so kann dies durch Anpassung der Parameter des Kabelmodells besser abgebildet werden.

Es ist deshalb bevorzugt vorgesehen, dass das System die erste Impulseinspeiseeinheit 32 aufweist, die zur Einspeisung mindestens eines ersten, elektrischen Impulses in die Kabelstrecke 4 ausgebildet ist. Dabei ist die Prozessoreinheit 8 ausgebildet, die erste Impulseinspeiseeinheit 32 derart zu steuern, so dass als erste Referenzimpulse 38 bezeichnet, elektrische Impulse mittels der ersten Impulseinspeiseeinheit 32 in die Kabelstrecke 4 eingespeist werden. Die erste Impulseinspeiseeinheit 32 ist beabstandet zu dem ersten Sensor 6 angeordnet. Vorzugsweise ist der erste Sensor 6 nämlich an dem ersten Ende 42 der Kabelstrecke 4 angeordnet, wohingegen die erste Impulseinspeiseeinheit 32 an dem gegenüberliegendem Ende 44 der Kabelstrecke 4 angeordnet ist. Dadurch kann gewährleistet werden, dass die in die Kabelstrecke 4 eingespeisten, ersten Referenzimpulse 38 die gesamte Kabelstrecke 4 durchlaufen müssen, bevor sie als elektrische Signale von dem ersten Sensor 6 erfasst werden können. Der erste Sensor 6 ist deshalb zur Erfassung elektrischer Signale ausgebildet, die als erste Referenzsignale bezeichnet und durch die ersten Referenzimpulse 38 verursacht sind. Wird also ein erster Referenzimpuls 38 von der ersten Impulseinspeiseeinheit 32 in die Kabelstrecke 4 eingespeist, so unterliegt dieser erste Referenzimpuls 38 der von der Kabelstrecke 4 verursachten Dämpfung und/oder Dispersion. Das erste Referenzsignal, das von dem ersten Sensor 6 erfasst wird, ist deshalb durch den ersten Referenzimpuls verursacht. Insbesondere kann das erste Referenzsignal der durch die Kabelstrecke 4 gedämpfte, erste Referenzimpuls 38 sein. Das erste Referenzsignal ist für gewöhnlich eine analoges Signal. Der erste Sensor 6 ist deshalb dazu vorzugsweise ausgebildet, jedes erste Referenzsignal zu digitalisieren. Außerdem ist der erste Sensor 6 dazu ausgebildet, um ein erstes Testsignal O über die Signalverbindung 58 an die Prozessoreinheit 8 zu übertragen, wobei das erste Testsignal O die ersten Referenzsignale repräsentiert.

Vorzugsweise ist die Prozessoreinheit 8 über die Steuerleitung 66 mit der ersten Impulseinspeiseeinheit 32 gekoppelt, um die erste Impulseinspeiseeinheit 32 zu steuern. Deshalb ist der Prozessoreinheit 8 auch der erste Referenzimpuls 38 bekannt. Wenn der zweite Sensor 28 und die erste Impulseinspeiseeinheit 32 eine gemeinsame Einheit bilden, kann zur Kontrolle der erste Referenzimpuls 38 von dem zweiten Sensor 28 erfasst und ein entsprechendes Signal über die Signalleitung 64 an die Prozessoreinheit 8 übertragen werden. Auch dadurch ist der Prozessoreinheit 8 der erste Referenzimpuls 38 bekannt. Über das erste Testsignal O von dem ersten Sensor 6 an die Prozessoreinheit 8 ist der Prozessoreinheit 8 außerdem das mindestens eine erste Referenzsignal bekannt. Aus einem ersten in die Kabelstrecke 4 eingespeisten Referenzimpuls 38 und einem zugehörigen ersten Referenzsignal kann deshalb in üblicher Weise das Übertragungsverhalten der Kabelstrecke 4 bestimmt werden. Hierzu kann die Prozessoreinheit 8 entsprechend ausgebildet sein. Das gleiche Übertragungsverhalten sollte grundsätzlich mit dem Kabelmodell möglich sein. Bei der erstmaligen Inbetriebnahme der Kabelstrecke 4 und/oder aufgrund Veränderungen der Kabelstrecke 4 kann es jedoch notwendig sein, die Parameter des Kabelmodells anzupassen, so dass das von dem Kabelmodell repräsentierte Übertragungsverhalten für die Kabelstrecke 4 und das tatsächliche Übertragungsverhalten der Kabelstrecke 4, das aus einem ersten Referenzimpuls und einem zugehörigen ersten Referenzsignal bestimmbar ist, übereinstimmen.

Deshalb ist die Prozessoreinheit 4 dazu konfiguriert, die Parameter des Kabelmodells basierend auf dem ersten Testsignal O anzupassen, so dass das von dem Kabelmodell repräsentierte Übertragungsverhalten für die Kabelstrecke 4 zu dem durch die erste Referenzimpulse und die ersten Referenzsignale repräsentierten, tatsächlichen Übertragungsverhalten der Kabelstrecke 4 entspricht.

Das System 2 kann außerdem eine zweite Impulseinspeiseeinheit 40 aufweisen, die ebenfalls zum Einspeisen von elektrischen Impulsen in die Kabelstrecke 4 ausgebildet ist. Die zweite Impulseinspeiseeinheit 40 kann entsprechende, zweite Referenzimpulse in die Kabelstrecke 4 einspeisen, so dass von dem ersten Sensor 6 ein zweites Referenzsignal erfassbar ist. Die zweite Impulseinspeiseeinheit 40 kann zusammen mit dem ersten Sensor 6 in analoger Weise verwendet und betrieben werden, wie es zuvor für die erste Impulseinspeiseeinheit 32 und dem zweiten Sensor 28 erläutert worden ist. So ist es beispielsweise möglich, dass beide Impulseinspeiseeinheiten 32, 40 parallel, zeitversetzt oder wechselweise Referenzimpulse in die Kabelstrecke 4 einspeisen und entsprechende Referenzsignale von den Sensoren 6, 28 erfasst werden. Die Referenzimpulse und Referenzsignale können sodann dazu verwendet werden, um das tatsächliche Übertragungsverhalten der Kabelstrecke 4 besser zu bestimmen.

Die zweite Impulseinspeiseeinheit 40 kann außerdem gemeinsam mit dem ersten Sensor 6 ausgebildet sein. Sie können also eine gemeinsame Einheit bilden.

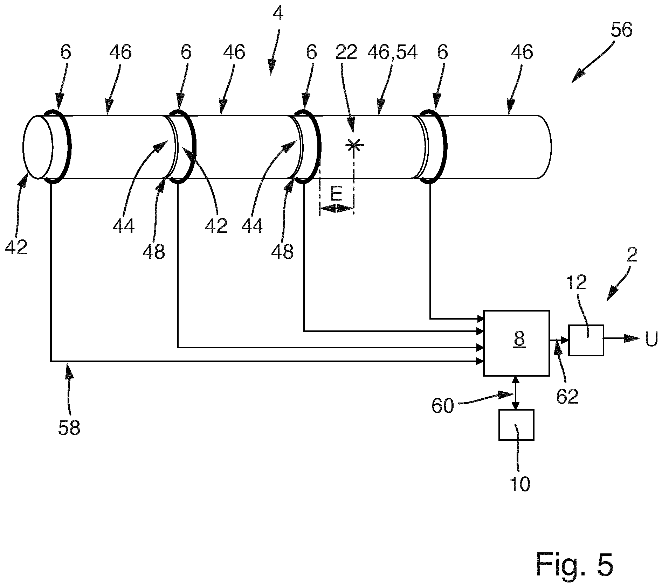

In der Figur 5 ist eine weitere vorteilhafte Ausgestaltung des Systems 2 dargestellt. Bezüglich der Prozessoreinheit 8, des Datenspeichers 10 und der Signalschnittstelle 12 wird auf die vorangegangenen Erläuterungen in analoger Weise Bezug genommen. Das System 2 ist jedoch für eine Kabelstrecke 4 angepasst, die mehrere Kabelsegmente 46 aufweist, die entlang der Kabelstrecke 4 hintereinander angeordnet sind, wobei die stirnseitig gegenüberliegenden Enden 44, 42 der Kabelsegmente 46 miteinander verbunden sind, um Koppelstellen 48 zu bilden. Die Koppelstellen 48 sind dabei derart ausgebildet, so dass elektrische Energie über die Koppelstelle 48 von Kabelsegment 46 zu Kabelsegment 46 übertragen werden kann.

Für jedes Kabelsegment 46 können die gleichen Ausgestaltungen des Systems 2 vorgesehen werden, wie sie zuvor im Zusammenhang mit den Figuren 1 bis 4 bereits erläutert worden sind. Deshalb wird für jedes Kabelsegment 46 auf die vorangegangenen Erläuterungen, bevorzugten Merkmale, Effekte und Vorteile, wie sie im Zusammenhang des Systems 2 mit dem Kabelsegment 4 erläutert worden sind, in analoger Weise Bezug genommen. Auf analoge Wiederholungen wird deshalb verzichtet.

Jedem Kabelsegment 46 ist ein erster Sensor 6 zugeordnet, der vorzugsweise über eine zugehörige Signalleitung 58 mit der Prozessoreinheit 8 verbunden ist. Außerdem ist jedem ersten Sensor 6 eine erste Kurvenmenge zugeordnet, die in dem Datenspeicher 10 gespeichert ist. Das System 2 weist also mehrere erste Sensoren 6 und mehrere erste Kurvenmengen 14 auf. Unter Bezugnahme auf die vorangegangenen Erläuterungen ist die Prozessoreinheit 8 dazu konfiguriert, für jeden ersten Sensor 6 den ersten Sensorabstand E zu einer tatsächlichen Teilentladung 22 zu bestimmen.

Tritt beispielsweise in einem der Kabelsegmente 46 eine Teilentladung 22 auf, ruft dies einen Impuls 20 hervor, der sich aufgrund der Koppelstellen 48 zwischen den Kabelsegmenten 46 über alle Kabelsegmente 46 ausbreitet. Dies kann grundsätzlich dazu führen, dass von den ersten Sensoren 6 der Kabelsegmente 46 jeweils ein erstes Entladungssignal erfasst wird, das durch die gleiche Teilentladung 22 verursacht ist, die jedoch nur in einer der Kabelsegmente 46 stattgefunden hat. Die Prozessoreinheit 8 ist deshalb dazu konfiguriert, dass Kabelsegment 46 mit der tatsächlichen Teilentladung 22 als identifiziertes Kabelsegment 54 basierend auf den ersten Sensorabständen E zu ermitteln. Mit anderen Worten kann die Prozessoreinheit 8 zunächst basierend auf den ersten Entladungssignalen eine jeweils zugehörige Entladungskurve und den daraus sich ergebenden ersten Sensorabstand E bestimmen. Somit kann für jedes Kabelsegment 46 ein zugehöriger erster Sensorabstand E ermittelt werden. Basierend auf diesen mehreren ersten Sensorabständen E kann die Prozessoreinheit 8 danach eines der Kabelsegmente 46 als identifiziertes Kabelsegment 54 bestimmen, an dem die Teilentladung 22 tatsächlich stattgefunden hat. Der diesem Kabelsegment 46 zugeordnete, erste Sensorabstand E bildet dann auch den tatsächlichen ersten Sensorabstand E, der von dem Ausgangssignal U repräsentiert sein kann. Das Ausgangssignal U kann zusätzlich das identifizierte Kabelsegment 46 indizieren. Somit ist es bevorzugt vorgesehen, dass die Signalschnittstelle 12 ausgestaltet ist, das Ausgangssignal U bereitzustellen, dass das identifizierte Kabelsegment 54 indiziert sowie den ersten Sensorabstand E des ersten Sensors 6 des identifizierten Kabelsegments 54 mit der tatsächlichen Teilentladung 22 repräsentiert.

Aus den Figuren 1, 3, 4 und 5 ist außerdem ein Übertragungssystem 56 zu entnehmen. Das Übertragungssystem 56 weist das System 2 auf. Dieses ist in den zuvor genannten Figuren in unterschiedlichen Ausgestaltungen dargestellt. Das Übertragungssystem 56 weist darüber hinaus auch die Kabelstrecke 4 als solche auf. Für das Übertragungssystem 56 wird deshalb auf die vorangegangenen Erläuterungen, bevorzugten Merkmale, Effekte und Vorteile in analoger Weise Bezug genommen.

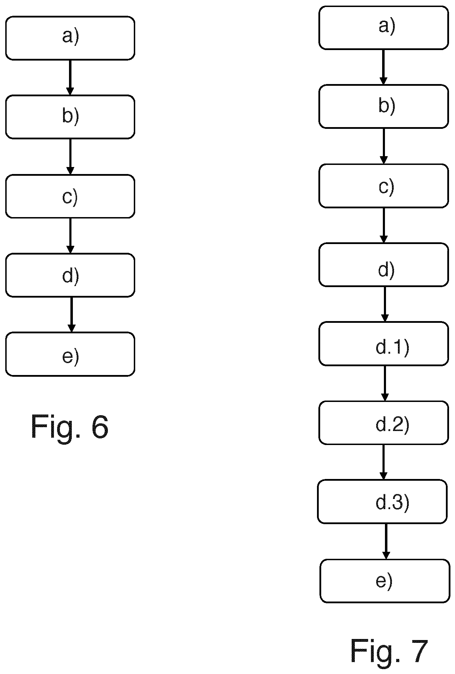

In der Figur 6 ist ein Ablaufdiagramm für eine vorteilhafte Ausgestaltung des Verfahrens zum Betrieb des Systems 2 dargestellt. Das Verfahren weist dabei die folgenden Schritte auf:
a) Übertragen von elektrischer Energie mittels der Kabelstrecke 4;
b) Erfassen eines elektrischen Signals mittels des ersten Sensors 6, das als erstes Entladungssignal 24 bezeichnet wird und durch eine tatsächliche Teilentladung 22 an der Kabelstrecke 4 verursacht ist;
c) Direktes oder indirektes Übertragen eines ersten Messsignals M, dass das erste Entladungssignal 24 repräsentiert, von dem ersten Sensor 6 an die Prozessoreinheit 8;
d) Bestimmen einer ersten Kurve 16 der ersten Kurvenmenge 14 als die erste Entladungskurve 26, die unter den ersten Kurven 16 der ersten Kurvenmenge 14 am besten mit dem ersten Entladungssignal 24 übereinstimmt, basierend auf dem ersten Messsignal M und mittels der Prozessoreinheit 8; und
e) Bestimmen eines ersten Sensorabstands E der tatsächlichen Teilentladung 22 zu dem ersten Sensor 6 basierend auf dem zur ersten Entladungskurve 26 zugehörigen Abstand mittels der Prozessoreinheit 8.

Bezüglich des Verfahrens wird auf die vorangegangenen Erläuterungen, bevorzugten Merkmale, Effekte und/oder Vorteile, wie sie für das System 2 zu den Figuren 1 - 5 bereits erläutert worden sind, in analoger Weise Bezug genommen. Auf eine entsprechende Wiederholung wird deshalb verzichtet.

Es sei jedoch angemerkt, dass die Verfahrensschritte a) bis e) in der genannten Reihenfolge ausgeführt werden können.

Sofern das Verfahren mit einem System 2 ausgeführt wird, wie es beispielsweise in der Figur 3 gezeigt ist, können zwischen den Schritten d) und e) die folgenden, weiteren Schritte d.1) bis d.3) ausgeführt werden. Ein entsprechender Ablaufplan ist in Figur 7 schematisch dargestellt. Die zusätzlichen Schritte lassen sich wie folgt zusammenfassen:
d.1) Erfassen eines elektrischen Signals mittels des zweiten Sensors 28, das als zweites Entladungssignal bezeichnet wird und durch die gleiche, tatsächliche Teilentladung 22 an der Kabelstrecke 4 verursacht ist;
d.2) Direktes oder indirektes Übertragen eines zweiten Messsignals N, das das zweite Entladungssignal repräsentiert, von dem zweiten Sensor 28 an die Prozessoreinheit 8;
d.3) Bestimmen einer zweiten Kurve der zweiten Kurvenmenge als die zweite Entladungskurve, die unter den zweiten Kurven der zweiten Kurvenmenge am Besten mit dem zweiten Entladungssignal übereinstimmt, basierend auf dem zweiten Messsignals mittels der Prozessoreinheit 8.

Dabei ist es außerdem bevorzugt vorgesehen, dass der erste Sensorabstand E in dem Schritt e) zusätzlich basierend auf dem zur zweiten Entladungskurve zugehörigen Abstand mittels der Prozessoreinheit 8 bestimmt wird.

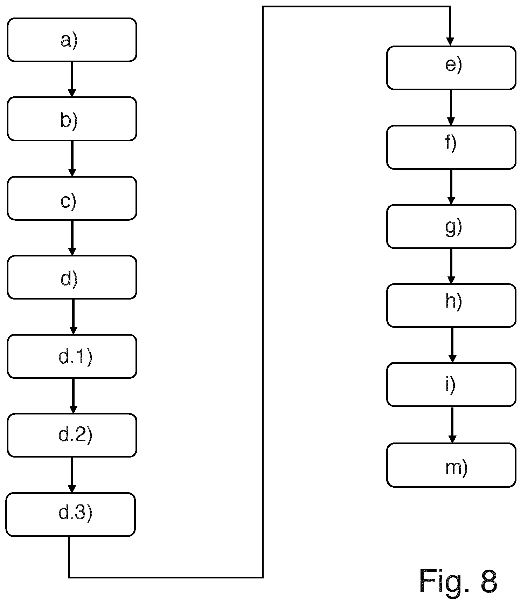

In der Figur 8 ist eine weitere Ausgestaltung des Verfahrens durch eine schematische Darstellung eines Ablaufplans wiedergegeben. Gemäß dieser Ausgestaltung des Verfahrens weist das Verfahren zusätzlich zu den Schritten, wie sie im Zusammenhang mit Figur 7 erläutert worden sind, außerdem die folgenden Schritte auf:
f) Steuern der ersten Impulseinspeiseeinheit 32 mittels der Prozessoreinheit 8, so dass als erste Referenzimpulse 38 bezeichnet, elektrische Impulse mittels der ersten Impulseinspeiseeinheit 32 in die Kabelstrecke 4 eingespeist werden;
g) Erfassen von als erste Referenzsignale bezeichnete, erste Signale, die jeweils durch einen der ersten Referenzimpulse 38 verursacht sind, mittels des ersten Sensors 6;
h) Direktes oder indirektes Übertragen von ersten Testsignalen O, die jeweils einen der ersten Referenzsignale repräsentiert, von dem ersten Sensor 6 an die Prozessoreinheit 8;
i) Anpassen der Parameter des Kabelmodels 4 mittels der Prozessoreinheit 8 und basierend auf dem mindestens einem ersten Testsignal O, so dass das von dem Kabelmodell 4 repräsentierte Übertragungsverhalten zu dem durch die ersten Referenzimpulse 38 und die ersten Referenzsignale repräsentierten, tatsächlichen Übertragungsverhalten der Kabelstrecke 4 entspricht.

Außerdem kann jedes der zuvor im Zusammenhang mit den Figuren 6 bis 8 erläuterte Verfahren den zusätzlichen Schritt m) aufweisen, der rein beispielhaft in dem Ablaufplan der Figur 8 mit dargestellt ist. Danach weist das Verfahren nämlich vorzugsweise auch den folgenden Schritt auf:
m) Übertragen eines Ausgangssignals U, das dem ersten Sensorabstand E repräsentiert, mittels der Signalschnittstelle 12.

Ergänzend sei darauf hingewiesen, dass "aufweisend" keine anderen Elemente oder Schritte ausschließt und "ein" oder "eine" keine Vielzahl ausschließt. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugszeichen in den Ansprüchen sind nicht als Einschränkung anzusehen.

### BEZUGSZEICHENLISTE

- A: Amplitude
- M: erstes Messsignal
- N: zweites Messsignal
- O: erstes Testsignal
- P: zweites Testsignal
- E: erster Sensorabstand
- F: zweiter Sensorabstand
- S: Sensorabstand
- T: Teilentladungsort
- U: Ausgangssignal
- L: Axialrichtung
- 2: System
- 4: Kabelstrecke
- 6: erster Sensor
- 8: Prozessoreinheit
- 10: Datenspeicher
- 12: Signalschnittstelle
- 14: erste Kurvenmenge
- 16: erste Kurve
- 20: Impuls
- 22: Teilentladung
- 24: erstes Entladungssignal
- 26: erste Entladungskurve
- 28: zweiter Sensor
- 32: erste Impulseinspeiseeinheit
- 38: erster Referenzimpuls
- 40: zweite Impulseinspeiseeinheit
- 42: erstes Ende
- 44: zweites Ende
- 46: Kabelsegment
- 48: Koppelstelle
- 54: identifiziertes Kabelsegment
- 56: Übertragungssystem
- 58: Signalverbindung
- 60: Signalverbindung
- 62: Signalverbindung
- 64: Signalverbindung
- 66: Steuerleitung
- 68: Steuerleitung

## Patentansprüche

1. System (2) für eine elektrische Kabelstrecke (4) zur Übertragung von elektrischer Energie, wobei das System (2) aufweist:
einen ersten Sensor (6) zur Erfassung elektrischer Signale der Kabelstrecke (4),
eine Prozessoreinheit (8),
einen Datenspeicher (10), und
eine Signalschnittstelle (12),
wobei der Datenspeicher (10) eine erste Kurvenmenge (14) aus mehreren ersten Kurven (16) mit jeweils einem zugehörigen Abstand zum ersten Sensor (6) gespeichert hat, wobei jede erste Kurve (16) eine mittels eines Kabelmodells der Kabelstrecke (4) vorbestimmte Impulsantwort eines elektrischen Impulses (20) durch eine modellierte Teilentladung (22) in dem für die jeweilige erste Kurve (16) zugehörigen Abstand zum ersten Sensor (6) an der Kabelstrecke (4) repräsentiert,
wobei der erste Sensor (6) zur Erfassung eines elektrischen Signals ausgebildet ist, das als erstes Entladungssignal (24) bezeichnet wird und durch eine tatsächliche Teilentladung (22) an der Kabelstrecke (4) verursacht ist, und zur direkten oder indirekten Übertragung eines ersten Messsignals M, das das erste Entladungssignal (24) repräsentiert, an die Prozessoreinheit (8) ausgebildet ist,
wobei die Prozessoreinheit (8) konfiguriert ist, basierend auf dem ersten Messsignal M eine der ersten Kurven (16) der ersten Kurvenmenge (14) als erste Entladungskurve (26) zu bestimmen, die unter den ersten Kurven (16) der ersten Kurvenmenge (14) am Besten mit dem ersten Entladungssignal (24) korreliert,
wobei die Prozessoreinheit (8) konfiguriert ist, einen ersten Sensorabstand E der tatsächlichen Teilentladung (22) zum ersten Sensor (6) basierend auf dem zur ersten Entladungskurve (26) zugehörigen Abstand zu bestimmen, und
wobei die Signalschnittstelle (12) ausgestaltet ist, ein Ausgangssignal U zu übertragen, das den ersten Sensorabstand E repräsentiert.

2. System (2) nach dem vorhergehenden Anspruch, **dadurch gekennzeichnet, dass**
das System (2) einen zweiten Sensor (28) zur Erfassung elektrischer Signale der Kabelstrecke (4) aufweist,
wobei der Datenspeicher (10) eine zweite Kurvenmenge aus mehreren zweiten Kurven mit jeweils einem zugehörigen Abstand zum zweiten Sensor (28) gespeichert hat, wobei jede zweite Kurve eine mittels des Kabelmodells der Kabelstrecke (4) vorbestimmte Impulsantwort eines elektrischen Impulses (20) durch eine modellierte Teilentladung (22) in dem für die jeweilige zweite Kurve zugehörigen Abstand zum zweiten Sensor (28) an der Kabelstrecke (4) repräsentiert,
wobei der erste Sensor (6) und der zweite Sensor (28) in einem vorbestimmten Sensorabstand voneinander an der Kabelstrecke (4) befestigbar sind,
wobei der zweite Sensor (28) zur Erfassung eines elektrischen Signals ausgebildet ist, das als zweites Entladungssignals bezeichnet wird und durch die gleiche, tatsächliche Teilentladung (22) an der Kabelstrecke (4) verursacht ist, und zur direkten oder indirekten Übertragung eines zweiten Messsignals N, das das zweite Entladungssignal repräsentiert, an die Prozessoreinheit (8) ausgebildet ist,
wobei die Prozessoreinheit (8) konfiguriert ist, basierend auf dem zweiten Messsignal N eine der zweiten Kurven der zweiten Kurvenmenge als zweite Entladungskurve zu bestimmen, die unter den zweiten Kurven am Besten mit dem zweiten Entladungssignal korreliert, und
wobei die Prozessoreinheit (8) konfiguriert ist, den ersten Sensorabstand E der tatsächlichen Teilentladung (22) zum ersten Sensor (6) basierend auf dem vorbestimmten Sensorabstand, dem der ersten Entladungskurve (26) zugehörigen Abstand und dem der zweiten Entladungskurve zugehörigen Abstand zu bestimmen.

3. System (2) nach einem der vorhergehenden Ansprüche, **dadurch gekennzeichnet, dass**
das System (2) eine erste Impulseinspeiseeinheit (32) zur Einspeisung mindestens eines ersten, elektrischen Impulses (20) in die Kabelstrecke (4) aufweist,
wobei die Prozessoreinheit (8) konfiguriert ist, Parameter des Kabelmodells zu verändern, das ein Übertragungsverhalten von elektrischen Impulsen (20) über die Kabelstrecke (4) repräsentiert,
wobei die Prozessoreinheit (8) ausgebildet ist, die erste Impulseinspeiseeinheit (32) zu steuern, so dass als erste Referenzimpulse (38) bezeichnete, elektrische Impulse (20) mittels der ersten Impulseinspeiseeinheit (32) in die Kabelstrecke (4) eingespeist werden,
wobei die erste Impulseinspeiseeinheit (32) beabstandet von dem ersten Sensor (6) angeordnet ist,
wobei der erste Sensor (6) zur Erfassung elektrischer Signale ausgebildet ist, die als erste Referenzsignale bezeichnet und durch die ersten Referenzimpulse (38) verursacht sind, und zur direkten oder indirekten Übertragung eines ersten Testsignals O, das die ersten Referenzsignale repräsentiert, an die Prozessoreinheit (8) ausgebildet ist, und
wobei die Prozessoreinheit (8) konfiguriert ist, die Parameter des Kabelmodells basierend auf dem ersten Testsignal O anzupassen, so dass das von dem Kabelmodell repräsentierte Übertragungsverhalten zu dem durch die ersten Referenzimpulse (38) und die ersten Referenzsignale repräsentierten, tatsächlichen Übertragungsverhalten der Kabelstrecke (4) entspricht.

4. System (2) nach Anspruch 3 in Kombination mit Anspruch 2, **dadurch gekennzeichnet, dass**
das System (2) eine zweite Impulseinspeiseeinheit (40) zur Einspeisung mindestens eines zweiten, elektrischen Impulses (20) in die Kabelstrecke (4) aufweist,
wobei die Prozessoreinheit (8) ausgebildet ist, die zweite Impulseinspeiseeinheit (40) zu steuern, so dass als zweite Referenzimpulse bezeichnete, elektrische Impulse (20) mittels der zweiten Impulseinspeiseeinheit (40) in die Kabelstrecke (4) eingespeist werden,
wobei die zweite Impulseinspeiseeinheit (40) beabstandet von dem zweiten Sensor (28) angeordnet ist,
wobei der zweite Sensor (28) zur Erfassung elektrischer Signale ausgebildet ist, die als zweite Referenzsignale bezeichnet und durch die zweiten Referenzimpulse verursacht sind, und zur direkten oder indirekten Übertragung eines zweiten Testsignals P, das die zweiten Referenzsignale repräsentiert, an die Prozessoreinheit (8) ausgebildet ist, und
wobei die Prozessoreinheit (8) konfiguriert ist, die Parameter des Kabelmodells basierend auf dem ersten Testsignal O und dem zweiten Testsignal P anzupassen, so dass das von dem Kabelmodell repräsentierte Übertragungsverhalten zu dem durch die ersten Referenzimpulse (38) und die ersten Referenzsignale und/oder durch die zweiten Referenzimpulse und zweiten Referenzsignale repräsentierten, tatsächlichen Übertragungsverhalten der Kabelstrecke (4) entspricht.

5. System (2) nach Anspruch 3, **dadurch gekennzeichnet, dass** der erste Sensor (6) und die zweite Impulseinspeiseeinheit (40) als eine gemeinsame, erste Wandlereinheit ausgebildet sind.

6. System (2) nach dem vorhergehenden Anspruch, **dadurch gekennzeichnet, dass** der zweite Sensor (28) und die erste Impulseinspeiseeinheit (32) als eine gemeinsame, zweite Wandlereinheit ausgebildet sind.

7. System (2) nach einem der vorhergehenden Ansprüche 3 bis 6, **dadurch gekennzeichnet, dass** die Prozessoreinheit (8) konfiguriert ist, die erste und/oder zweite Impulseinspeiseeinheit (32, 40) periodisch zum Einspeisen von Referenzimpulsen und nach jedem Einspeisen der Referenzimpulse zum Anpassen der Parameter des Kabelmodells ausgebildet ist.

8. System (2) nach einem der vorhergehenden Ansprüche, **dadurch gekennzeichnet, dass** der erste Sensor (6) zur periodischen Erfassung elektrischer Signale der Kabelstrecke (4) ausgebildet ist, und die Prozessoreinheit (8) konfiguriert ist, bei jedem Fall, wenn das vom ersten Sensor (6) erfasste elektrische Signal ein erstes Entladungssignal (24) bildet, die zugehörige erste Entladungskurve (26) zu bestimmen und den ersten Sensorabstand E des ersten Sensors (6) zu der jeweiligen Teilentladung (22) basierend auf der ersten Entladungskurve (26) zu bestimmen.

9. System (2) nach dem vorhergehenden Anspruch in Kombination mit Anspruch 2, **dadurch gekennzeichnet, dass** der zweite Sensor (28) zur periodischen Erfassung elektrischer Signale der Kabelstrecke (4) ausgebildet ist, und die Prozessoreinheit (8) konfiguriert ist, bei jedem Fall, wenn das vom zweiten Sensor (28) erfasste elektrische Signal ein zweites Entladungssignal bildet, die zugehörige zweite Entladungskurve zu bestimmen und den ersten Sensorabstand E der jeweiligen Teilentladung (22) zum ersten Sensor (6) basierend auf dem vorbestimmten Sensorabstand, dem der ersten Entladungskurve (26) zugehörigen Abstand und dem der zweiten Entladungskurve zugehörigen Abstand zu bestimmen.

10. System (2) nach einem der vorhergehenden Ansprüche 8 bis 9, **dadurch gekennzeichnet, dass** die Prozessoreinheit (8) konfiguriert ist, eine Häufigkeit von mehreren tatsächlichen Teilentladungen (22) in dem gleichen Abstand zum ersten Sensor (6) zu ermitteln, und wobei das Ausgangssignal U außerdem die Häufigkeit repräsentiert.

11. System (2) nach einem der vorhergehenden Ansprüche 8 bis 10, **dadurch gekennzeichnet, dass** die Prozessoreinheit (8) konfiguriert ist, wenigstens eine Kenngröße von mehreren tatsächlichen Teilentladungen (22) in dem gleichen Abstand zum ersten Sensor (6) zu ermitteln, und wobei das Ausgangssignal U außerdem die ermittelte Kenngröße repräsentiert.

12. System (2) nach einem der vorhergehenden Ansprüche 9 bis 11, **dadurch gekennzeichnet, dass** die Prozessoreinheit (8) konfiguriert ist, ein Warnsignal zu erzeugen, wenn die Häufigkeit der Teilentladungen (22) größer als eine vorbestimmte Schwellwerthäufigkeit ist und/oder wenn die ermittelte Kenngröße der Teilentladungen (22) größer als eine vorbestimmte Schwellwertkenngröße ist, und wobei die Signalschnittstelle (12) zum Übertragen des Warnsignals ausgebildet ist.

13. System (2) nach einem der vorhergehenden Ansprüche 9 bis 11, **dadurch gekennzeichnet, dass** die Prozessoreinheit (8) konfiguriert ist, einen Alterungszustand der Kabelstrecke (4) basierend auf der Häufigkeit der Teilentladungen (22) und/oder der wenigstens einen ermittelten Kenngröße der Teilentladungen (22) und/oder der angepassten Parameter zu ermitteln, wobei das Ausgangssignal U außerdem den Alterungszustand repräsentiert.

14. System (2) nach einem der vorhergehenden Ansprüche, **dadurch gekennzeichnet, dass**
die Kabelstrecke (4) mehrere Kabelsegmente (46) aufweist, die entlang der Kabelstrecke (4) hintereinander angeordnet sind, wobei stirnseitig gegenüberliegende Enden von Kabelsegmenten (46) miteinander verbunden sind, um Koppelstellen (48) zu bilden,
wobei jedem Kabelsegment (46) ein erster Sensor (6) und eine erste Kurvenmenge (14) für den jeweiligen ersten Sensor (6) zugeordnet ist, so dass das System (2) mehrere erste Sensoren (6) aufweist und mehrere erste Kurvenmengen (14) von dem Datenspeicher (10) gespeichert sind,
wobei die Prozessoreinheit (8) konfiguriert ist, für jeden ersten Sensor (6) den ersten Sensorabstand E der tatsächlichen Teilentladung (22) zum jeweiligen ersten Sensor (6) zu bestimmen,
wobei die Prozessoreinheit (8) konfiguriert ist, das Kabelsegment (46) mit der Teilentladung (22) als identifiziertes Kabelsegment (46) basierend auf den ersten Sensorabständen E zu ermitteln, und
wobei die Signalschnittstelle (12) ausgebildet ist, das Ausgangssignal U bereitzustellen, das das identifizierte Kabelsegment (46) indiziert sowie den ersten Sensorabstand E des ersten Sensors (6) des identifizierten Kabelelements (46) von der Teilentladung (22) repräsentiert.

15. Übertragungssystem (56) zur Übertragung von elektrischer Energie, aufweisend:
eine Kabelstrecke (4), und
ein System (2) nach einem der vorhergehenden Ansprüche.

16. Verfahren zum Betrieb eines Systems (2) für eine elektrische Kabelstrecke (4) zur Übertragung von elektrischer Energie, wobei das System (4) einen ersten Sensor (6) zur Erfassung elektrischer Signale der Kabelstrecke (4), eine Prozessoreinheit (8), einen Datenspeicher (10) und eine Signalschnittstelle (12) aufweist, wobei der Datenspeicher (10) eine erste Kurvenmenge (14) aus mehreren ersten Kurven (16) mit jeweils einem zugehörigen Abstand zum ersten Sensor (6) gespeichert hat, wobei jede erste Kurve (16) eine mittels eines Kabelmodells der Kabelstrecke (4) vorbestimmte Impulsantwort eines elektrischen Impulses (20) durch eine modellierte Teilentladung (22) in dem für die jeweilige erste Kurve (16) zugehörigen Abstand zum ersten Sensor (6) an der Kabelstrecke (4) repräsentiert, und wobei das Verfahren die folgenden Schritte aufweist:
a) Übertragen von elektrischer Energie mittels der Kabelstrecke (4),
b) Erfassen eines elektrischen Signals, das als erstes Entladungssignal (24) bezeichnet wird und durch eine tatsächliche Teilentladung (22) an der Kabelstrecke (4) verursacht ist, mittels des ersten Sensors (6),
c) Direktes oder indirektes Übertragen eines ersten Messsignals M, das das erste Entladungssignal (24) repräsentiert, von dem ersten Sensor (6) an die Prozessoreinheit (8),
d) Bestimmen einer ersten Kurve (16) der ersten Kurvenmenge (14) als die erste Entladungskurve (26), die unter den ersten Kurven (16) der ersten Kurvenmenge (14) am Besten mit dem ersten Entladungssignal (24) korreliert, basierend auf dem ersten Messsignal M und mittels der Prozessoreinheit (8), und
e) Bestimmen eines ersten Sensorabstands E der tatsächlichen Teilentladung (22) zum ersten Sensor (6) basierend auf dem zur ersten Entladungskurve (26) zugehörigen Abstand mittels der Prozessoreinheit (8).

17. Verfahren nach dem vorhergehenden Anspruch, **dadurch gekennzeichnet, dass** das System (2) einen zweiten Sensor (6) zur Erfassung elektrischer Signale der Kabelstrecke (4) aufweist, wobei der Datenspeicher (10) eine zweite Kurvenmenge aus mehreren zweiten Kurven mit jeweils einem zugehörigen Abstand zum zweiten Sensor (28) gespeichert hat, wobei jede zweite Kurve eine mittels des Kabelmodells der Kabelstrecke (4) vorbestimmte Impulsantwort eines elektrischen Impulses (20) durch eine modellierte Teilentladung (22) in dem für die jeweilige zweite Kurve zugehörigen Abstand zum zweiten Sensor (28) an der Kabelstrecke (4) repräsentiert, wobei der erste Sensor (6) und der zweite Sensor (28) in einem vorbestimmten Sensorabstand voneinander an der Kabelstrecke (4) angeordnet sind, und wobei das Verfahren die weiteren, folgenden Schritte aufweist:
d.1) Erfassen eines elektrischen Signals, das als zweites Entladungssignal bezeichnet wird und durch die gleiche, tatsächliche Teilentladung (22) an der Kabelstrecke (4) verursacht ist, mittels des zweiten Sensors,
d.2) Direktes oder indirektes Übertragen eines zweiten Messsignals N, das das zweite Entladungssignal repräsentiert, von dem zweiten Sensor (28) an die Prozessoreinheit (8), und
d.3) Bestimmen einer zweiten Kurve der zweiten Kurvenmenge als die zweite Entladungskurve, die unter den zweiten Kurven der zweiten Kurvenmenge am Besten mit dem zweiten Entladungssignal korreliert, basierend auf dem zweiten Messsignal N und mittels der Prozessoreinheit (8),
und wobei der erste Sensorabstand E in Schritt e) zusätzlich basierend auf dem zur zweiten Entladungskurve zugehörigen Abstand mittels der Prozessoreinheit (8) bestimmt wird.

18. Verfahren nach einem der vorhergehenden Ansprüche 16 bis 17, **dadurch gekennzeichnet, dass** das System (2) eine erste Impulseinspeiseeinheit (32) zur Einspeisung mindestens eines ersten, elektrischen Impulses (20) in die Kabelstrecke (4) aufweist, wobei die Prozessoreinheit (8) konfiguriert ist, Parameter des Kabelmodells zu verändern, das ein Übertragungsverhalten von elektrischen Impulsen (20) über die Kabelstrecke (4) repräsentiert, wobei die erste Impulseinspeiseeinheit (32) beabstandet von dem ersten Sensor (6) angeordnet ist und wobei das Verfahren die weiteren, folgenden Schritte aufweist:
f) Steuern der ersten Impulseinspeiseeinheit (32) mittels der Prozessoreinheit (8), so dass als erste Referenzimpulse (38) bezeichnete, elektrische Impulse (20) mittels der ersten Impulseinspeiseeinheit (32) in die Kabelstrecke (4) eingespeist werden,
g) Erfassen von als erste Referenzsignale bezeichnete, elektrische Signale, die jeweils durch einen der ersten Referenzimpulse (38) verursacht sind, mittels des ersten Sensors (6),
h) Direktes oder indirektes Übertragen von ersten Testsignalen O, die jeweils eines der ersten Referenzsignale repräsentieren, von dem ersten Sensor (6) an die Prozessoreinheit (8), und
i) Anpassen der Parameter des Kabelmodells mittels der Prozessoreinheit (8) und basierend auf dem mindestens einen ersten Testsignal O, so dass das von dem Kabelmodell repräsentierte Übertragungsverhalten zu dem durch die ersten Referenzimpulse (38) und die ersten Referenzsignale repräsentierten, tatsächlichen Übertragungsverhalten der Kabelstrecke (4) entspricht.

19. Verfahren nach dem vorhergehenden Anspruch, **dadurch gekennzeichnet, dass** das System (2) eine zweite Impulseinspeiseeinheit (40) zur Einspeisung mindestens eines zweiten, elektrischen Impulses (20) in die Kabelstrecke (4) aufweist, wobei die zweite Impulseinspeiseeinheit (40) beabstandet von dem zweiten Sensor (28) angeordnet ist, und wobei das Verfahren die weiteren, folgenden Schritte aufweist:
j) Steuern der zweiten Impulseinspeiseeinheit (40) mittels der Prozessoreinheit (8), so dass als zweite Referenzimpulse bezeichnete, elektrische Impulse (20) mittels der zweiten Impulseinspeiseeinheit (40) in die Kabelstrecke (4) eingespeist werden,
k) Erfassen eines elektrischen Signals, das als zweites Referenzsignal bezeichnet wird und durch die zweiten Referenzimpulse verursacht ist, mittels des zweiten Sensors (28), und
l) Direktes oder indirektes Übertragen eines zweiten Testsignals P, das das zweite Referenzsignal repräsentiert, von dem zweiten Sensor (28) an die Prozessoreinheit (8),
wobei die Parameter des Kabelmodells in Schritt i) mittels der Prozessoreinheit (8) basierend auf dem ersten Testsignal O und dem zweiten Testsignal P derart angepasst werden, so dass das von dem Kabelmodell repräsentierte Übertragungsverhalten zu dem durch die ersten Referenzimpulse (38) und die zweiten Referenzsignale und/oder durch die zweiten Referenzimpulse und zweiten Referenzsignale repräsentierten, tatsächlichen Übertragungsverhalten der Kabelstrecke (4) entspricht.

20. Verfahren nach einem der vorhergehenden Ansprüche 16 bis 19, **dadurch gekennzeichnet, dass** das Verfahren den weiteren, folgenden Schritt aufweist:
m) Übertragen eines Ausgangssignals U, das den ersten Sensorabstand E repräsentiert, mittels der Signalschnittstelle (12).

21. Verfahren nach einem der vorhergehenden Ansprüche 16 bis 20, **dadurch gekennzeichnet, dass** die Gruppe der Verfahrensschritte a) bis e) einmalig oder wiederholt ausgeführt werden.

22. Verfahren nach einem der vorhergehenden Ansprüche 19 bis 21, **dadurch gekennzeichnet, dass** die Schritte g) bis j) oder die Schritte g) bis m) einmalig, periodisch oder vor jedem Ausführen der Gruppe der Verfahrensschritte a) bis e) ausgeführt werden.

23. Verfahren nach einem der vorhergehenden Ansprüche 19 bis 22, **dadurch gekennzeichnet, dass** die erste und/oder zweite Kurvenmenge (14) mit dem durch die angepassten Parameter aktualisierten Kabelmodell mittels der Prozessoreinheit (8) berechnet und in dem Datenspeicher (10) gespeichert wird, vorzugsweise nach jeder Anpassung der Parameter des Kabelmodells.

## Claims

1. System (2) for an electrical cable route (4) for the transmission of electrical energy, the system (2) having
a first sensor (6) for detecting electrical signals from the cable section (4),
a processor unit (8),
a data memory (10), and
a signal interface (12),
the data memory (10) having stored a first set of curves (14) comprising a plurality of first curves (16), each with an associated distance from the first sensor (6), each first curve (16) representing an impulse response, predetermined by means of a cable model of the cable route (4), of an electrical impulse (20) by a modeled partial discharge (22) at the distance from the first sensor (6) on the cable route (4) associated with the respective first curve (16),
wherein the first sensor (6) is designed to detect an electrical signal, which is referred to as a first discharge signal (24) and is caused by an actual partial discharge (22) on the cable section (4), and is designed to transmit a first measurement signal M, which represents the first discharge signal (24), directly or indirectly to the processor unit (8),
wherein the processor unit (8) is configured to determine, based on the first measurement signal M, one of the first curves (16) of the first set of curves (14) as the first discharge curve (26) which, among the first curves (16) of the first set of curves (14), correlates best with the first discharge signal (24),
wherein the processor unit (8) is configured to determine a first sensor distance E of the actual partial discharge (22) to the first sensor (6) based on the distance associated with the first discharge curve (26), and
wherein the signal interface (12) is designed to transmit an output signal U which represents the first sensor distance E.

2. System (2) according to the preceding claim, **characterized in that**
the system (2) has a second sensor (28) for detecting electrical signals from the cable section (4),
the data memory (10) having stored a second set of curves comprising a plurality of second curves, each with an associated distance from the second sensor (28), each second curve representing an impulse response, predetermined by means of the cable model of the cable route (4), of an electrical impulse (20) by a modeled partial discharge (22) at the distance from the second sensor (28) on the cable route (4) associated with the respective second curve,
wherein the first sensor (6) and the second sensor (28) can be attached to the cable section (4) at a predetermined sensor spacing from one another,
wherein the second sensor (28) is designed to detect an electrical signal, which is referred to as a second discharge signal and is caused by the same, actual partial discharge (22) on the cable section (4), and is designed to transmit a second measurement signal N, which represents the second discharge signal, directly or indirectly to the processor unit (8),
wherein the processor unit (8) is configured to determine, based on the second measurement signal N, one of the second curves of the second set of curves as the second discharge curve that best correlates with the second discharge signal among the second curves, and
wherein the processor unit (8) is configured to determine the first sensor distance E of the actual partial discharge (22) to the first sensor (6) based on the predetermined sensor distance, the distance associated with the first discharge curve (26) and the distance associated with the second discharge curve.

3. System (2) according to one of the preceding claims, **characterized in that**
the system (2) has a first pulse feed unit (32) for feeding at least a first electrical pulse (20) into the cable section (4),
wherein the processor unit (8) is configured to change parameters of the cable model representing a transmission behavior of electrical pulses (20) over the cable route (4),
wherein the processor unit (8) is designed to control the first pulse feed unit (32), so that electrical pulses (20) designated as first reference pulses (38) are fed into the cable section (4) by means of the first pulse feed unit (32),
wherein the first pulse feed unit (32) is arranged at a distance from the first sensor (6),
wherein the first sensor (6) is adapted to detect electrical signals, referred to as first reference signals, caused by the first reference pulses (38) and is adapted to directly or indirectly transmit a first test signal O, representing the first reference signals, to the processor unit (8), and
wherein the processor unit (8) is configured to adjust the parameters of the cable model based on the first test signal O, so that the transmission behavior represented by the cable model corresponds to the actual transmission behavior of the cable route (4) represented by the first reference pulses (38) and the first reference signals.

4. System (2) according to claim 3 in combination with claim 2, **characterized in that**
the system (2) has a second pulse feed unit (40) for feeding at least a second electrical pulse (20) into the cable section (4),
wherein the processor unit (8) is designed to control the second pulse feed unit (40), so that electrical pulses (20) designated as second reference pulses are fed into the cable section (4) by means of the second pulse feed unit (40),
wherein the second pulse feed unit (40) is arranged at a distance from the second sensor (28),
wherein the second sensor (28) is adapted to detect electrical signals, referred to as second reference signals, caused by the second reference pulses, and is adapted to directly or indirectly transmit a second test signal P representing the second reference signals to the processor unit (8), and
wherein the processor unit (8) is configured to adjust the parameters of the cable model based on the first test signal O and the second test signal P, so that the transmission behavior represented by the cable model corresponds to the actual transmission behavior of the cable route (4) represented by the first reference pulses (38) and the first reference signals and/or by the second reference pulses and second reference signals.

5. System (2) according to claim 3, **characterized in that** the first sensor (6) and the second pulse feed unit (40) are designed as a common, first transducer unit.

6. System (2) according to the preceding claim, **characterized in that** the second sensor (28) and the first pulse feed unit (32) are designed as a common, second transducer unit.

7. System (2) according to any one of the preceding claims 3 to 6, **characterized in that** the processor unit (8) is configured to periodically feed the first and/or second pulse feed unit (32, 40) for feeding reference pulses and after each feeding of the reference pulses for adjusting the parameters of the cable model.

8. System (2) according to one of the preceding claims, **characterized in that** the first sensor (6) is designed to periodically detect electrical signals of the cable section (4), and the processor unit (8) is configured to determine the associated first discharge curve (26) in each case when the electrical signal detected by the first sensor (6) forms a first discharge signal (24), and to determine the first sensor distance E of the first sensor (6) to the respective partial discharge (22) based on the first discharge curve (26).

9. System (2) according to the preceding claim in combination with claim 2, **characterized in that** the second sensor (28) is designed to periodically detect electrical signals of the cable section (4), and the processor unit (8) is configured to determine the associated second discharge curve in each case when the electrical signal detected by the second sensor (28) forms a second discharge signal, to determine the associated second discharge curve and to determine the first sensor distance E of the respective partial discharge (22) to the first sensor (6) based on the predetermined sensor distance, the distance associated with the first discharge curve (26) and the distance associated with the second discharge curve.

10. The system (2) according to any one of the preceding claims 8 to 9, **characterized in that** the processor unit (8) is configured to determine a frequency of a plurality of actual partial discharges (22) at the same distance from the first sensor (6), and wherein the output signal U further represents the frequency.

11. System (2) according to any one of the preceding claims 8 to 10, **characterized in that** the processor unit (8) is configured to determine at least one characteristic of a plurality of actual partial discharges (22) at the same distance from the first sensor (6), and wherein the output signal U further represents the determined characteristic.

12. System (2) according to one of the preceding claims 9 to 11, **characterized in that** the processor unit (8) is configured to generate a warning signal if the frequency of the partial discharges (22) is greater than a predetermined threshold frequency and/or if the determined characteristic variable of the partial discharges (22) is greater than a predetermined threshold characteristic variable, and wherein the signal interface (12) is designed to transmit the warning signal.

13. System (2) according to one of the preceding claims 9 to 11, **characterized in that** the processor unit (8) is configured to determine an aging state of the cable section (4) based on the frequency of the partial discharges (22) and/or the at least one determined characteristic of the partial discharges (22) and/or the adjusted parameters, wherein the output signal U further represents the aging state.

14. System (2) according to one of the preceding claims, **characterized in that**
the cable section (4) has a plurality of cable segments (46) which are arranged one behind the other along the cable section (4), wherein opposite ends of cable segments (46) are connected to one another at the end face in order to form coupling points (48),
wherein each cable segment (46) is associated with a first sensor (6) and a first set of curves (14) for the respective first sensor (6), so that the system (2) comprises a plurality of first sensors (6) and a plurality of first sets of curves (14) are stored by the data memory (10),
wherein the processor unit (8) is configured to determine for each first sensor (6) the first sensor distance E of the actual partial discharge (22) to the respective first sensor (6),
wherein the processor unit (8) is configured to determine the cable segment (46) with the partial discharge (22) as the identified cable segment (46) based on the first sensor distances E, and
wherein the signal interface (12) is designed to provide the output signal U which indicates the identified cable segment (46) and represents the first sensor distance E of the first sensor (6) of the identified cable element (46) from the partial discharge (22).

15. Transmission system (56) for transmitting electrical energy, comprising:
a cable section (4), and
a system (2) according to one of the preceding claims.

16. Method for operating a system (2) for an electrical cable route (4) for transmitting electrical energy, the system (4) having a first sensor (6) for detecting electrical signals of the cable route (4), a processor unit (8), a data memory (10) and a signal interface (12), the data memory (10) having stored a first set of curves (14) comprising a plurality of first curves (16) each with an associated distance from the first sensor (6), wherein each first curve (16) represents an impulse response of an electrical impulse (20) predetermined by means of a cable model of the cable route (4) by a modeled partial discharge (22) at the distance from the first sensor (6) on the cable route (4) associated with the respective first curve (16), and wherein the method comprises the following steps:
a) Transmission of electrical energy via the cable route (4),
b) Detection of an electrical signal, which is referred to as a first discharge signal (24) and is caused by an actual partial discharge (22) on the cable section (4), by means of the first sensor (6),
c) Direct or indirect transmission of a first measurement signal M, which represents the first discharge signal (24), from the first sensor (6) to the processor unit (8),
d) determining a first curve (16) of the first curve set (14) as the first discharge curve (26) which, among the first curves (16) of the first curve set (14), best correlates with the first discharge signal (24), based on the first measurement signal M and by means of the processor unit (8), and
e) Determining a first sensor distance E of the actual partial discharge (22) to the first sensor (6) based on the distance associated with the first discharge curve (26) by means of the processor unit (8).

17. Method according to the preceding claim, **characterized in that** the system (2) has a second sensor (6) for detecting electrical signals of the cable route (4), the data memory (10) having stored a second set of curves comprising a plurality of second curves, each with an associated distance from the second sensor (28), wherein each second curve represents an impulse response of an electrical impulse (20) predetermined by means of the cable model of the cable section (4) by a modeled partial discharge (22) at the distance associated with the respective second curve from the second sensor (28) on the cable section (4), wherein the first sensor (6) and the second sensor (28) are arranged at a predetermined sensor distance from one another on the cable section (4), and wherein the method comprises the further following steps:
d.1) Detection of an electrical signal, referred to as the second discharge signal, which is caused by the same actual partial discharge (22) on the cable section (4), by means of the second sensor,
d.2) directly or indirectly transmitting a second measurement signal N, representing the second discharge signal, from the second sensor (28) to the processor unit (8), and
d.3) determining a second curve of the second curve set as the second discharge curve that best correlates with the second discharge signal among the second curves of the second curve set, based on the second measurement signal N and by means of the processor unit (8),
and wherein the first sensor distance E in step e) is additionally determined based on the distance associated with the second discharge curve by means of the processor unit (8).

18. Method according to any one of the preceding claims 16 to 17, **characterized in that** the system (2) comprises a first pulse injection unit (32) for injecting at least a first electrical pulse (20) into the cable path (4), wherein the processor unit (8) is configured to change parameters of the cable model representing a transmission behaviour of electrical pulses (20) over the cable path (4), wherein the first pulse injection unit (32) is arranged spaced apart from the first sensor (6), and wherein the method comprises the further following steps:
f) Controlling the first pulse feed unit (32) by means of the processor unit (8), so that electrical pulses (20) designated as first reference pulses (38) are fed into the cable section (4) by means of the first pulse feed unit (32),
g) Detection of electrical signals, referred to as first reference signals, each caused by one of the first reference pulses (38), by means of the first sensor (6),
h) Directly or indirectly transmitting first test signals O, each representing one of the first reference signals, from the first sensor (6) to the processor unit (8), and
i) adapting the parameters of the cable model by means of the processor unit (8) and based on the at least one first test signal O, so that the transmission behavior represented by the cable model corresponds to the actual transmission behavior of the cable route (4) represented by the first reference pulses (38) and the first reference signals.

19. Method according to the preceding claim, **characterized in that** the system (2) has a second pulse feed unit (40) for feeding at least one second electrical pulse (20) into the cable section (4), the second pulse feed unit (40) being arranged at a distance from the second sensor (28), and the method having the further following steps:
j) Controlling the second pulse feed unit (40) by means of the processor unit (8), so that electrical pulses (20) designated as second reference pulses are fed into the cable section (4) by means of the second pulse feed unit (40),
k) detecting an electrical signal, referred to as a second reference signal, caused by the second reference pulses by means of the second sensor (28), and
l) Direct or indirect transmission of a second test signal P, which represents the second reference signal, from the second sensor (28) to the processor unit (8),
wherein the parameters of the cable model are adapted in step i) by means of the processor unit (8) based on the first test signal O and the second test signal P in such a way that the transmission behavior represented by the cable model corresponds to the actual transmission behavior of the cable route (4) represented by the first reference pulses (38) and the second reference signals and/or by the second reference pulses and second reference signals.

20. Method according to any one of the preceding claims 16 to 19, **characterized in that** the method comprises the further following step:
m) Transmission of an output signal U, which represents the first sensor distance E, by means of the signal interface (12).

21. Method according to one of the preceding claims 16 to 20, **characterized in that** the group of method steps a) to e) are carried out once or repeatedly.

22. Method according to one of the preceding claims 19 to 21, **characterized in that** steps g) to j) or steps g) to m) are carried out once, periodically or before each execution of the group of method steps a) to e).

23. Method according to one of the preceding claims 19 to 22, **characterized in that** the first and/or second set of curves (14) is calculated with the cable model updated by the adjusted parameters by means of the processor unit (8) and stored in the data memory (10), preferably after each adjustment of the parameters of the cable model.

## Revendications

1. Système (2) pour une ligne de câbles électriques (4) pour la transmission d'énergie électrique, le système (2) comprenant :
un premier capteur (6) pour détecter des signaux électriques de la section de câble (4),
une unité de traitement (8),
une mémoire de données (10), et
une interface de signal (12),
la mémoire de données (10) ayant mémorisé un premier ensemble de courbes (14) constitué de plusieurs premières courbes (16) avec respectivement une distance associée par rapport au premier capteur (6), chaque première courbe (16) représentant une réponse impulsionnelle prédéterminée au moyen d'un modèle de câble de la section de câble (4) d'une impulsion électrique (20) par une décharge partielle modélisée (22) à la distance associée pour la première courbe respective (16) par rapport au premier capteur (6) sur la section de câble (4),
le premier capteur (6) étant conçu pour détecter un signal électrique, qui est désigné comme premier signal de décharge (24) et qui est provoqué par une décharge partielle (22) effective sur la section de câble (4), et pour transmettre directement ou indirectement un premier signal de mesure M, qui représente le premier signal de décharge (24), à l'unité de traitement (8),
dans lequel l'unité de traitement (8) est configurée pour déterminer, sur la base du premier signal de mesure M, l'une des premières courbes (16) du premier ensemble de courbes (14) en tant que première courbe de décharge (26) qui est la mieux corrélée avec le premier signal de décharge (24) parmi les premières courbes (16) du premier ensemble de courbes (14),
l'unité de traitement (8) étant configurée pour déterminer une première distance de capteur E de la décharge partielle réelle (22) au premier capteur (6) sur la base de la distance associée à la première courbe de décharge (26), et
l'interface de signal (12) étant configurée pour transmettre un signal de sortie U qui représente la première distance de capteur E.

2. Système (2) selon la revendication précédente, **caractérisé en ce que**
le système (2) comporte un deuxième capteur (28) pour détecter des signaux électriques de la section de câble (4),
la mémoire de données (10) ayant mémorisé un deuxième ensemble de courbes constitué de plusieurs deuxièmes courbes ayant chacune une distance associée par rapport au deuxième capteur (28), chaque deuxième courbe représentant une réponse impulsionnelle prédéterminée au moyen du modèle de câble de la section de câble (4) d'une impulsion électrique (20) par une décharge partielle modélisée (22) à la distance associée pour la deuxième courbe respective par rapport au deuxième capteur (28) sur la section de câble (4),
dans lequel le premier capteur (6) et le deuxième capteur (28) peuvent être fixés sur la section de câble (4) à une distance de capteur prédéterminée l'un de l'autre,
le deuxième capteur (28) étant conçu pour détecter un signal électrique, appelé deuxième signal de décharge, qui est provoqué par la même décharge partielle réelle (22) sur la section de câble (4), et pour transmettre directement ou indirectement à l'unité de traitement (8) un deuxième signal de mesure N représentant le deuxième signal de décharge,
dans lequel l'unité de traitement (8) est configurée pour déterminer, sur la base du second signal de mesure N, l'une des secondes courbes du second ensemble de courbes en tant que seconde courbe de décharge qui, parmi les secondes courbes, est la mieux corrélée au second signal de décharge, et
dans lequel l'unité de traitement (8) est configurée pour déterminer la première distance de capteur E de la décharge partielle réelle (22) au premier capteur (6) sur la base de la distance de capteur prédéterminée, de la distance associée à la première courbe de décharge (26) et de la distance associée à la seconde courbe de décharge.

3. Système (2) selon l'une des revendications précédentes, **caractérisé en ce que**
le système (2) présente une première unité d'injection d'impulsions (32) pour l'injection d'au moins une première impulsion électrique (20) dans la section de câble (4),
dans lequel l'unité de traitement (8) est configurée pour modifier des paramètres du modèle de câble qui représente un comportement de transmission d'impulsions électriques (20) sur le trajet de câble (4),
l'unité de processeur (8) étant conçue pour commander la première unité d'alimentation en impulsions (32), de sorte que des impulsions électriques (20), désignées comme premières impulsions de référence (38), sont alimentées dans la section de câble (4) au moyen de la première unité d'alimentation en impulsions (32),
dans lequel la première unité d'alimentation en impulsions (32) est disposée à distance du premier capteur (6),
le premier capteur (6) étant conçu pour détecter des signaux électriques appelés premiers signaux de référence et provoqués par les premières impulsions de référence (38), et étant conçu pour transmettre directement ou indirectement à l'unité de traitement (8) un premier signal de test O représentant les premiers signaux de référence, et
dans lequel l'unité de traitement (8) est configurée pour adapter les paramètres du modèle de câble sur la base du premier signal de test O, de sorte que le comportement de transmission représenté par le modèle de câble correspond au comportement de transmission réel de la section de câble (4) représenté par les premières impulsions de référence (38) et les premiers signaux de référence.

4. Système (2) selon la revendication 3 en combinaison avec la revendication 2, **caractérisé en ce que**
le système (2) présente une deuxième unité d'injection d'impulsions (40) pour l'injection d'au moins une deuxième impulsion électrique (20) dans la section de câble (4),
l'unité de processeur (8) étant conçue pour commander la deuxième unité d'alimentation en impulsions (40), de sorte que des impulsions électriques (20), désignées comme deuxièmes impulsions de référence, sont alimentées dans le chemin de câbles (4) au moyen de la deuxième unité d'alimentation en impulsions (40),
dans lequel la deuxième unité d'alimentation en impulsions (40) est disposée à distance du deuxième capteur (28),
le deuxième capteur (28) étant conçu pour détecter des signaux électriques, qui sont désignés comme des deuxièmes signaux de référence et qui sont provoqués par les deuxièmes impulsions de référence, et étant conçu pour transmettre directement ou indirectement à l'unité de traitement (8) un deuxième signal de test P, qui représente les deuxièmes signaux de référence, et
l'unité de traitement (8) étant configurée pour adapter les paramètres du modèle de câble sur la base du premier signal de test O et du deuxième signal de test P, de sorte que le comportement de transmission représenté par le modèle de câble correspond au comportement de transmission réel de la section de câble (4) représenté par les premières impulsions de référence (38) et les premiers signaux de référence et/ou par les deuxièmes impulsions de référence et les deuxièmes signaux de référence.

5. Système (2) selon la revendication 3, **caractérisé en ce que** le premier capteur (6) et la deuxième unité d'injection d'impulsions (40) sont conçus comme une première unité de conversion commune.

6. Système (2) selon la revendication précédente, **caractérisé en ce que** le deuxième capteur (28) et la première unité d'injection d'impulsions (32) sont conçus comme une deuxième unité de conversion commune.

7. Système (2) selon l'une des revendications précédentes 3 à 6, **caractérisé en ce que** l'unité de traitement (8) est configurée pour alimenter périodiquement la première et/ou la deuxième unité d'injection d'impulsions (32, 40) en impulsions de référence et pour ajuster les paramètres du modèle de câble après chaque injection des impulsions de référence.

8. Système (2) selon l'une des revendications précédentes, **caractérisé en ce que** le premier capteur (6) est conçu pour détecter périodiquement des signaux électriques de la section de câble (4), et l'unité de traitement (8) est configurée pour déterminer, à chaque fois que le signal électrique détecté par le premier capteur (6) forme un premier signal de décharge (24), la première courbe de décharge (26) correspondante et pour déterminer la première distance de capteur E du premier capteur (6) par rapport à la décharge partielle (22) respective sur la base de la première courbe de décharge (26).

9. Système (2) selon la revendication précédente en combinaison avec la revendication 2, **caractérisé en ce que** le deuxième capteur (28) est conçu pour détecter périodiquement des signaux électriques du chemin de câble (4), et l'unité de traitement (8) est configurée pour, dans chaque cas, lorsque le signal électrique détecté par le deuxième capteur (28) forme un deuxième signal de décharge, déterminer la deuxième courbe de décharge associée et déterminer la première distance de capteur E de la décharge partielle respective (22) par rapport au premier capteur (6) sur la base de la distance de capteur prédéterminée, de la distance associée à la première courbe de décharge (26) et de la distance associée à la deuxième courbe de décharge.

10. Système (2) selon l'une quelconque des revendications précédentes 8 à 9, **caractérisé en ce que** l'unité de traitement (8) est configurée pour déterminer une fréquence de plusieurs décharges partielles réelles (22) à la même distance du premier capteur (6), et dans lequel le signal de sortie U est en outre représentatif de ladite fréquence.

11. Système (2) selon l'une des revendications précédentes 8 à 10, **caractérisé en ce que** l'unité de traitement (8) est configurée pour déterminer au moins une caractéristique de plusieurs décharges partielles réelles (22) à la même distance du premier capteur (6), et dans lequel le signal de sortie U est en outre représentatif de la caractéristique déterminée.

12. Système (2) selon l'une des revendications précédentes 9 à 11, **caractérisé en ce que** l'unité de traitement (8) est configurée pour générer un signal d'avertissement lorsque la fréquence des décharges partielles (22) est supérieure à une fréquence de seuil prédéterminée et/ou lorsque la grandeur caractéristique déterminée des décharges partielles (22) est supérieure à une grandeur caractéristique de seuil prédéterminée, et dans lequel l'interface de signal (12) est conçue pour transmettre le signal d'avertissement.

13. Système (2) selon l'une quelconque des revendications 9 à 11 précédentes, **caractérisé en ce que** l'unité de traitement (8) est configurée pour déterminer un état de vieillissement du chemin de câble (4) sur la base de la fréquence des décharges partielles (22) et/ou de l'au moins une caractéristique déterminée des décharges partielles (22) et/ou des paramètres adaptés, le signal de sortie U étant en outre représentatif de l'état de vieillissement.

14. Système (2) selon l'une des revendications précédentes, **caractérisé en ce que**
la section de câble (4) présente plusieurs segments de câble (46) qui sont disposés les uns derrière les autres le long de la section de câble (4), des extrémités opposées côté frontal de segments de câble (46) étant reliées entre elles pour former des points de couplage (48),
dans lequel chaque segment de câble (46) est associé à un premier capteur (6) et à un premier ensemble de courbes (14) pour le premier capteur respectif (6), de sorte que le système (2) comprend une pluralité de premiers capteurs (6) et une pluralité de premiers ensembles de courbes (14) sont stockés par la mémoire de données (10),
l'unité de traitement (8) étant configurée pour déterminer, pour chaque premier capteur (6), la première distance de capteur E de la décharge partielle effective (22) par rapport au premier capteur respectif (6),
dans lequel l'unité de traitement (8) est configurée pour déterminer le segment de câble (46) avec la décharge partielle (22) comme segment de câble identifié (46) sur la base des premières distances de capteur E, et
dans lequel l'interface de signal (12) est adaptée pour fournir le signal de sortie U qui indique le segment de câble identifié (46) et représente la première distance de capteur E du premier capteur (6) de l'élément de câble identifié (46) par rapport à la décharge partielle (22).

15. Système de transmission (56) pour la transmission d'énergie électrique, comprenant :
une section de câble (4), et
un système (2) selon l'une des revendications précédentes.

16. Procédé d'exploitation d'un système (2) pour une section de câble électrique (4) pour la transmission d'énergie électrique, le système (4) présentant un premier capteur (6) pour la saisie de signaux électriques de la section de câble (4), une unité de processeur (8), une mémoire de données (10) et une interface de signaux (12), la mémoire de données (10) ayant mémorisé un premier ensemble de courbes (14) constitué de plusieurs premières courbes (16) avec respectivement une distance associée au premier capteur (6), chaque première courbe (16) représentant une réponse impulsionnelle prédéterminée au moyen d'un modèle de câble de la section de câble (4) d'une impulsion électrique (20) par une décharge partielle modélisée (22) à la distance associée pour la première courbe respective (16) par rapport au premier capteur (6) sur la section de câble (4), et le procédé comprenant les étapes suivantes :
a) Transmission de l'énergie électrique au moyen du tronçon de câble (4),
b) la détection, au moyen du premier capteur (6), d'un signal électrique, appelé premier signal de décharge (24), provoqué par une décharge partielle réelle (22) sur la section de câble (4),
c) la transmission directe ou indirecte d'un premier signal de mesure M, représentant le premier signal de décharge (24), du premier capteur (6) à l'unité de traitement (8),
d) déterminer une première courbe (16) du premier ensemble de courbes (14) en tant que première courbe de décharge (26) qui est la mieux corrélée avec le premier signal de décharge (24) parmi les premières courbes (16) du premier ensemble de courbes (14), sur la base du premier signal de mesure M et au moyen de l'unité de traitement (8), et
e) déterminer une première distance de capteur E de la décharge partielle réelle (22) par rapport au premier capteur (6) sur la base de la distance associée à la première courbe de décharge (26) au moyen de l'unité de traitement (8).

17. Procédé selon la revendication précédente, **caractérisé en ce que** le système (2) comporte un deuxième capteur (6) pour détecter des signaux électriques de la section de câble (4), la mémoire de données (10) ayant mémorisé un deuxième ensemble de courbes constitué de plusieurs deuxièmes courbes avec chacune une distance associée au deuxième capteur (28), chaque deuxième courbe représentant une réponse impulsionnelle prédéterminée au moyen du modèle de câble de la section de câble (4) d'une impulsion électrique (20) par une décharge partielle modélisée (22) à la distance associée pour la deuxième courbe respective par rapport au deuxième capteur (28) sur la section de câble (4), le premier capteur (6) et le deuxième capteur (28) étant disposés à une distance de capteur prédéterminée l'un de l'autre sur la section de câble (4), et le procédé comprenant les autres étapes suivantes :
d.1) détecter, au moyen du deuxième capteur, un signal électrique, appelé deuxième signal de décharge, qui est provoqué par la même décharge partielle (22) réelle sur le tronçon de câble (4),
d.2) la transmission directe ou indirecte d'un deuxième signal de mesure N, représentant le deuxième signal de décharge, du deuxième capteur (28) à l'unité de traitement (8), et
d.3) déterminer une deuxième courbe du deuxième ensemble de courbes comme étant la deuxième courbe de décharge qui, parmi les deuxièmes courbes du deuxième ensemble de courbes, est la mieux corrélée avec le deuxième signal de décharge, sur la base du deuxième signal de mesure N et au moyen de l'unité de traitement (8),
et dans lequel la première distance de capteur E est déterminée à l'étape e) en outre sur la base de la distance associée à la deuxième courbe de décharge au moyen de l'unité de traitement (8).

18. Procédé selon l'une quelconque des revendications 16 à 17 précédentes, **caractérisé en ce que** le système (2) comprend une première unité d'injection d'impulsions (32) pour injecter au moins une première impulsion électrique (20) dans le chemin de câble (4), l'unité de traitement (8) étant configurée pour modifier des paramètres du modèle de câble représentant un comportement de transmission d'impulsions électriques (20) sur le chemin de câble (4), la première unité d'injection d'impulsions (32) étant située à distance du premier capteur (6), le procédé comprenant les étapes supplémentaires suivantes :
f) commander la première unité d'alimentation en impulsions (32) au moyen de l'unité de traitement (8), de sorte que des impulsions électriques (20), désignées comme premières impulsions de référence (38), sont alimentées dans le chemin de câbles (4) au moyen de la première unité d'alimentation en impulsions (32),
g) la détection, au moyen du premier capteur (6), de signaux électriques, appelés premiers signaux de référence, qui sont chacun provoqués par l'une des premières impulsions de référence (38),
h) la transmission directe ou indirecte de premiers signaux de test O, chacun représentant l'un des premiers signaux de référence, du premier capteur (6) à l'unité de traitement (8), et
i) l'adaptation des paramètres du modèle de câble au moyen de l'unité de traitement (8) et sur la base du au moins un premier signal de test O, de sorte que le comportement de transmission représenté par le modèle de câble corresponde au comportement de transmission réel de la section de câble (4) représenté par les premières impulsions de référence (38) et les premiers signaux de référence.

19. Procédé selon la revendication précédente, **caractérisé en ce que** le système (2) comprend une seconde unité d'injection d'impulsions (40) pour injecter au moins une seconde impulsion électrique (20) dans le chemin de câble (4), la seconde unité d'injection d'impulsions (40) étant située à distance du second capteur (28), le procédé comprenant les étapes supplémentaires suivantes :
j) commander la deuxième unité d'alimentation en impulsions (40) au moyen de l'unité de traitement (8), de telle sorte que des impulsions électriques (20), appelées deuxièmes impulsions de référence, soient alimentées dans le chemin de câbles (4) au moyen de la deuxième unité d'alimentation en impulsions (40),
k) la détection d'un signal électrique, appelé deuxième signal de référence, provoqué par les deuxièmes impulsions de référence, au moyen du deuxième capteur (28), et
l) la transmission directe ou indirecte d'un deuxième signal de test P, représentant le deuxième signal de référence, du deuxième capteur (28) à l'unité de traitement (8),
les paramètres du modèle de câble étant adaptés à l'étape i) au moyen de l'unité de traitement (8) sur la base du premier signal de test O et du second signal de test P de telle sorte que le comportement de transmission représenté par le modèle de câble corresponde au comportement de transmission réel de la section de câble (4) représenté par les premières impulsions de référence (38) et les seconds signaux de référence et/ou par les secondes impulsions de référence et les seconds signaux de référence.

20. Procédé selon l'une quelconque des revendications précédentes 16 à 19, **caractérisé en ce que** le procédé comprend l'étape supplémentaire suivante :
m) transmettre un signal de sortie U représentant la première distance de capteur E au moyen de l'interface de signal (12).

21. Procédé selon l'une quelconque des revendications précédentes 16 à 20, **caractérisé en ce que** le groupe d'étapes de procédé a) à e) est exécuté une seule fois ou de manière répétée.

22. Procédé selon l'une quelconque des revendications précédentes 19 à 21, **caractérisé en ce que** les étapes g) à j) ou les étapes g) à m) sont exécutées une fois, périodiquement ou avant chaque exécution du groupe d'étapes a) à e) du procédé.

23. Procédé selon l'une des revendications précédentes 19 à 22, **caractérisé en ce que** le premier et/ou le deuxième ensemble de courbes (14) est calculé avec le modèle de câble mis à jour par les paramètres adaptés au moyen de l'unité de traitement (8) et est stocké dans la mémoire de données (10), de préférence après chaque adaptation des paramètres du modèle de câble.
